# EUROPEAN PATENT APPLICATION

(11) **EP 4 836 605 A1**
(43) Date of publication of application: **04.11.2026**
(21) Application number: 24912829.9
(22) Date of filing: 24.12.2024
(51) Int. Cl.: H05K 5/03, H01R 13/52, H05K 5/06, H05K 7/00

(54) **ELECTRONIC DEVICE**

(30) Priority: 28.12.2023 JP 2023223172
(71) Applicant: Asahi Denso Co., Ltd., Shizuoka 434-0046 (JP); Kubota Corporation, Osaka-shi, Osaka 530-0011 (JP)
(72) Inventor: MIZUNO, Naoki, Hamamatsu-shi, Shizuoka 434-0046 (JP); MIURA, Keisuke, Sakai-shi, Osaka 590-0908 (JP); ANAMI, Hiroyuki, Sakai-shi, Osaka 590-0908 (JP)
(74) Representative: Cabinet Beau de Loménie
(86) International application number: PCT/JP2024/045723
(87) International publication number: WO 2025/142943

(57) **Abstract**

To prevent, in the case where connectors are not attached, foreign matter from easily entering a housing.

An electronic device (1) includes a housing (3) to house an electronic substrate (2), the housing (3) including a plurality of connector-receiving portions (18) in a peripheral wall (11), at least one connector (5) located at at least one of the plurality of connector-receiving portions (18), and at least one cover (60) located at at least one unoccupied connector-receiving portion which is at least one of the plurality of connector-receiving portions (18) at which no connectors (5) are located. The at least one cover (60) includes a main body (61) which is located at the at least one unoccupied connector-receiving portion to cover the at least one unoccupied connector-receiving portion, and an attachable portion (62) joined to the main body (61) and attachable to the electronic substrate (2).

## Description

### Technical Field

The present invention relates to electronic devices which can be installed on, for example, industrial machines such as agricultural machines and construction machines.

### Background Art

Patent Literature 1 discloses an electronic control unit in which a plurality of connectors are attached to a substrate and the substrate with the plurality of connectors attached thereto is housed in a housing including a first cover and a second cover.

### Citation List

### Patent Literature

PTL 1: Japanese Unexamined Patent Application Publication No. 2022-093054

### Summary of Invention

### Technical Problem

With regard to the electronic control unit including a plurality of connectors such as that disclosed in Patent Literature 1, there may be cases in which, when some of the plurality of connectors are not used, covers are attached to those connectors to prevent foreign matter from entering the housing of the electronic control unit. In the case where the electronic control unit such as that disclosed in Patent Literature 1 is configured such that connectors themselves are not attached to the substrate, it is not assumed that covers are attached instead of the connectors.

The present invention was made in view of the above issue, and an object thereof is to provide electronic devices each of which can prevent, in the case where connectors are not attached, foreign matter from easily entering the housing.

### Solution to Problem

Technical solutions of the present invention to attain the above object include the following characteristic features.

An electronic device according to an example embodiment of the present invention includes a housing to house an electronic substrate, the housing including a plurality of connector-receiving portions in a peripheral wall, at least one connector located at at least one of the plurality of connector-receiving portions, and at least one cover located at at least one unoccupied connector-receiving portion which is at least one of the plurality of connector-receiving portions at which no connectors are located, wherein the at least one cover includes a main body which is located at the at least one unoccupied connector-receiving portion to cover the at least one unoccupied connector-receiving portion, and an attachable portion joined to the main body and attachable to the electronic substrate.

The attachable portion may include a substrate attachable portion to be attached to the electronic substrate and a housing attachable portion to be attached to the housing.

the housing attachable portion may be attached to the housing by at least one fastener. The electronic substrate may include a through portion to allow the at least one fastener to pass therethrough.

The housing may include a case body including a horizontal wall and the peripheral wall joined to the horizontal wall, and a lid body attachable to the case body. The peripheral wall may include a seal groove to receive a seal member in an inside thereof. Advantageous Effects of Invention

With the present invention, it is possible to prevent, in the case where connectors are not attached, foreign matter from easily entering the housing.

### Brief Description of Drawings

[FIG. 1] FIG. 1 is an exploded perspective view of an electronic device.
[FIG. 2] FIG. 2 is an exploded perspective view of a case body.
[FIG. 3] FIG. 3 is a perspective view of a case body.
[FIG. 4] FIG. 4 is a perspective view in which a seal member is attached to a case body.
[FIG. 5] FIG. 5 is a perspective view of the inside of a case body as seen from a lid body-side.
[FIG. 6] FIG. 6 is a plan view of a case body.
[FIG. 7] FIG. 7 is a plan view in which a seal member is attached to a case body.
[FIG. 8] FIG. 8 is a side view of a case body in which a first connector is attached to the case body.
[FIG. 9] FIG. 9 is a cross-sectional view of a case body in which a first connector is attached to the case body.
[FIG. 10] FIG. 10 is a side view of a case body in which a second connector is attached to the case body.
[FIG. 11] FIG. 11 is a cross-sectional view in which a second connector is attached to a case body.
[FIG. 12] FIG. 12 is a perspective view of the outside of a case body as viewed from a lid body.
[FIG. 13] FIG. 13 is a plan view of the interior of a container portion.
[FIG. 14] FIG. 14 is a cross-sectional view of an electronic device.
[FIG. 15] FIG. 15 is a cross-sectional view different from FIG. 14.
[FIG. 16] FIG. 16 is an enlarged view of a discharging structure and a communication path.
[FIG. 17] FIG. 17 is a perspective view of a case body that is a variation of a discharging structure.
[FIG. 18] FIG. 18 is an enlarged view of a discharging structure different from the discharging structure of FIG. 16.
[FIG. 19] FIG. 19 is a plan view of a cover 60b.
[FIG. 20] FIG. 20 is a rear view of a cover 60b.
[FIG. 21] FIG. 21 is a side view of a cover 60b.
[FIG. 22] FIG. 22 is a front view of a cover 60b.
[FIG. 23] FIG. 23 is a first cross-sectional view in which a cover 60b is attached to an unoccupied connector-receiving portion.
[FIG. 24] FIG. 24 is a cross-sectional section view in which a cover 60b is attached to an unoccupied connector-receiving portion.
[FIG. 25] FIG. 25 is a perspective view in which a cover 60b is attached to a housing and an electronic substrate.
[FIG. 26] FIG. 26 is a plan view of a cover 60a.
[FIG. 27] FIG. 27 is a rear view of a cover 60a.
[FIG. 28] FIG. 28 is a side view of a cover 60a.
[FIG. 29] FIG. 29 is a front view of a cover 60a.
[FIG. 30] FIG. 30 is a first cross-sectional view in which a cover 60a is attached to an unoccupied connector-receiving portion.
[FIG. 31] FIG. 31 is a second cross-sectional view in which a cover 60a is attached to an unoccupied connector-receiving portion.
[FIG. 32] FIG. 32 is a perspective view in which a cover 60a is attached to a housing and an electronic substrate.

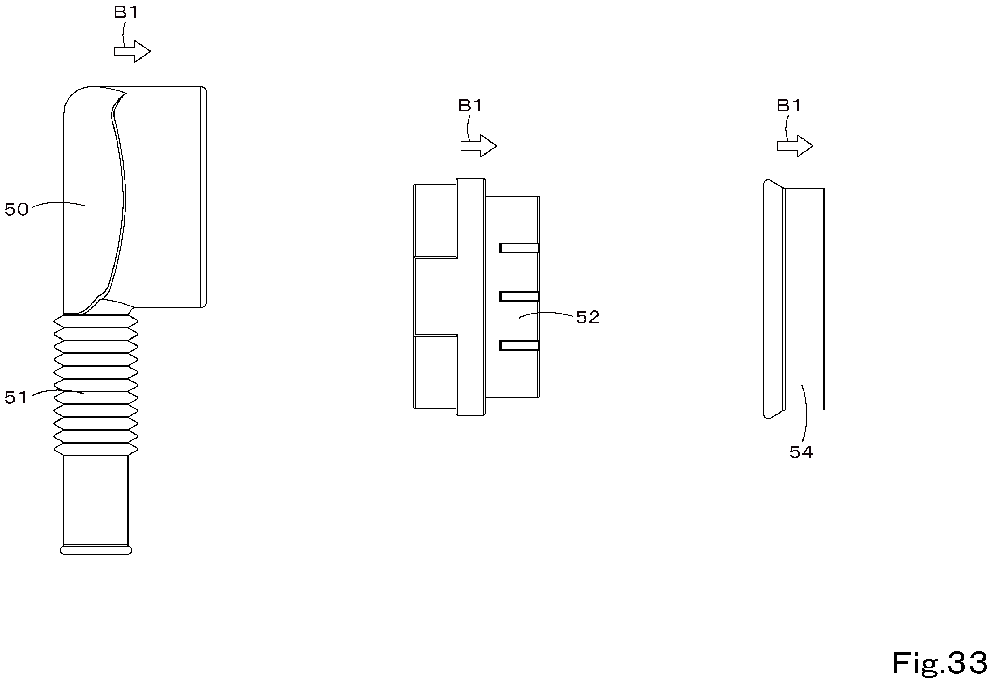

[FIG. 33] FIG. 33 illustrates types of connectors.
[FIG. 34] FIG. 34 is a first diagram illustrating how connectors are attached.
[FIG. 35] FIG. 35 is a second diagram illustrating how connectors are attached.
[FIG. 36] FIG. 36 is a third diagram illustrating how connectors are attached.
[FIG. 37] FIG. 37 is a fourth diagram illustrating how connectors are attached.
[FIG. 38] FIG. 38 is a fifth diagram illustrating how connectors are attached.

### Description of Embodiments

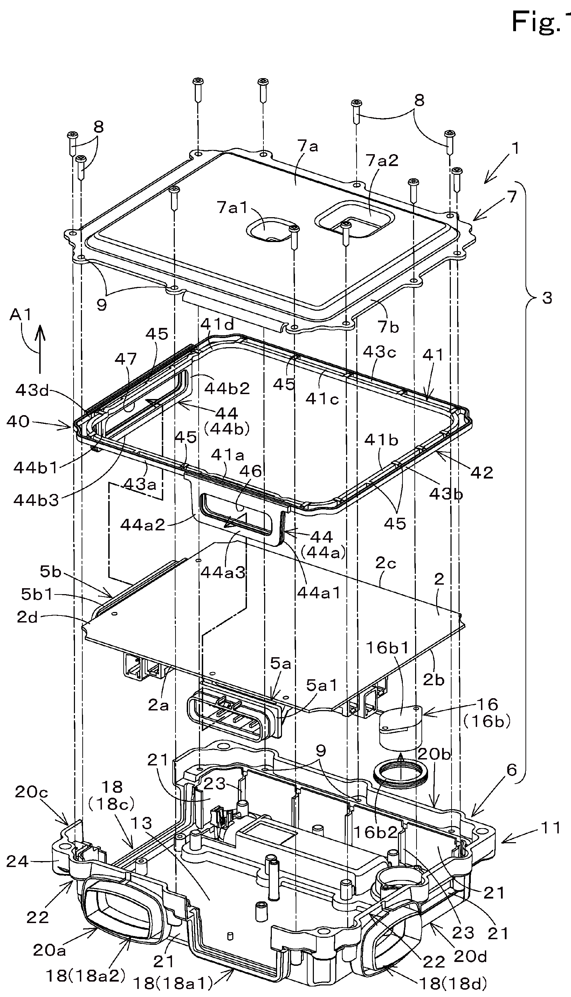

FIG. 1 is an exploded perspective view of an electronic device 1 of an example embodiment of the present invention. The electronic device 1 is configured to be installed in or on an industrial machine such as an agricultural machine or construction machine. The electronic device 1 is, for example, a controller to perform control and/or the like relating to traveling, working, and/or the like of the industrial machine and/or control a display installed in the industrial machine. The electronic device 1 may be a communicator to enable communication between the industrial machine and an external network. The electronic device 1 of the present example embodiment is configured to function as a controller or a communicator selectively by replacing an electronic substrate 2 with another one.

As shown in FIG. 1, the electronic device 1 includes the electronic substrate 2 and a housing 3. The electronic substrate 2 includes electronic components including CPU(s), semiconductor device(s) such as one or more memories, and/or resistor(s), and/or the like. The electronic substrate 2 has a sheet shape (rectangular shape), and includes circuitry and/or the like on its front surface, rear surface, and/or the like. A plurality of connectors 5 are attached to the housing 3.

The housing 3 is configured to house the electronic substrate 2, and has a box shape. The housing 3 includes a case body 6 and a lid body 7. The case body 6 is a case to house the electronic substrate 2. The lid body 7 is attachable to the case body 6. The case body 6 and the lid body 7 have hole(s) 9 for insertion of fastener(s) 8 such as bolt(s), and are configured such that, when the case body 6 and the lid body 7 are aligned with each other and the fastener(s) 8 is/are inserted in the hole(s) 9 and tightened, a space is defined inside the housing 3 and the electronic substrate 2 is housed in the space. The case body 6 is made from a material such as resin, and the lid body 7 is made from a material such as metal. The case body 6 and the lid body 7 may be made from other material(s), and there is no limitation as to the material.

For convenience of description, in the following description, one of the up-down directions in FIG. 1 that extends from down to the lid body 7 may be referred to as "toward-lid direction" (A1 direction), and a portion of something that is closer to the lid body 7 than the other portions may be referred to as "lid-side portion". The other of the up-down directions that extends from top toward a horizontal wall 10 (flat portion 13) may be referred to as "toward-horizontal-wall direction" (A2 direction), and a portion of something that is closer to the horizontal wall 10 than the other portions may be referred to as "horizontal wall 10-side portion". A direction from a predetermined position toward the inside of the case body 6 may be referred to as "case-inward direction", and a direction from a predetermined position toward the outside of the case body 6 may be referred to as "case-outward direction".

As shown in FIGS. 1 to 3, the case body 6 includes the horizontal wall 10 and a peripheral wall 11 joined to the horizontal wall 10. The horizontal wall 10 includes the flat portion 13 and a container portion 14. The container portion 14 includes a lid portion 15. The flat portion 13 includes a surface that is flat in a horizontal direction. The container portion 14 includes a portion for a device 16 to be housed, and is recessed from the flat portion 13 in the case-inward direction. The lid portion 15 covers an outer side of the container portion 14 and is detachably attached to the container portion 14. The container portion 14 is configured to house the device 16. In the present example embodiment, the device 16 includes an electric storage device 16a such as a battery and an electrical device 16b actuated by at least the electric storage device 16a. The electrical device 16b is a speaker.

The peripheral wall 11 is a portion joined to the horizontal wall 10. The peripheral wall 11 extends from an edge portion of the horizontal wall 10 in a direction away from the edge portion of the horizontal wall 10. That is, the peripheral wall 11 is a portion extending toward the lid body 7 in the state in which the lid body 7 is attached to the case body 6. The peripheral wall 11 includes receiving portion(s) 19 at a lid-side portion thereof.

The peripheral wall 11 includes a plurality of vertical walls. The plurality of vertical walls include a first vertical wall 20a, a second vertical wall 20b, a third vertical wall 20c, and a fourth vertical wall 20d. The first vertical wall 20a is opposite (faces) the second vertical wall 20b, and the third wall 20c opposite (faces) the fourth vertical wall 20d. One end of the first vertical wall 20a is joined to the third vertical wall 20c, and the opposite end of the first vertical wall 20a is joined to the fourth vertical wall 20d. One end of the second vertical wall 20b is joined to the third vertical wall 20c and the opposite end of the second vertical wall 20b is joined to the fourth vertical wall 20d. In plan view, the peripheral wall 11 has a rectangular shape defined by the first vertical wall 20a, the second vertical wall 20b, the third vertical wall 20c, and the fourth vertical wall 20d.

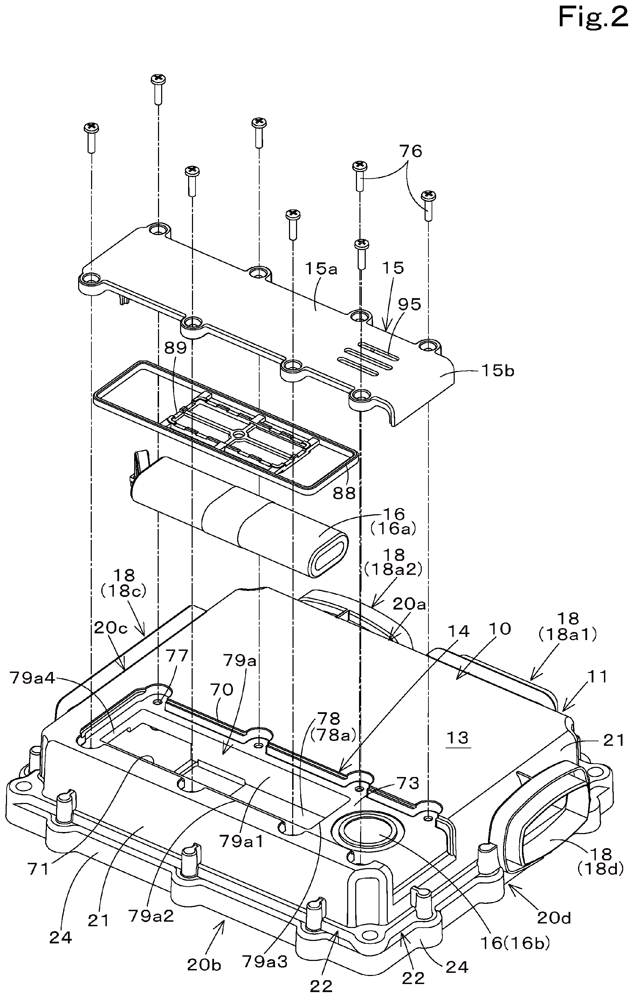

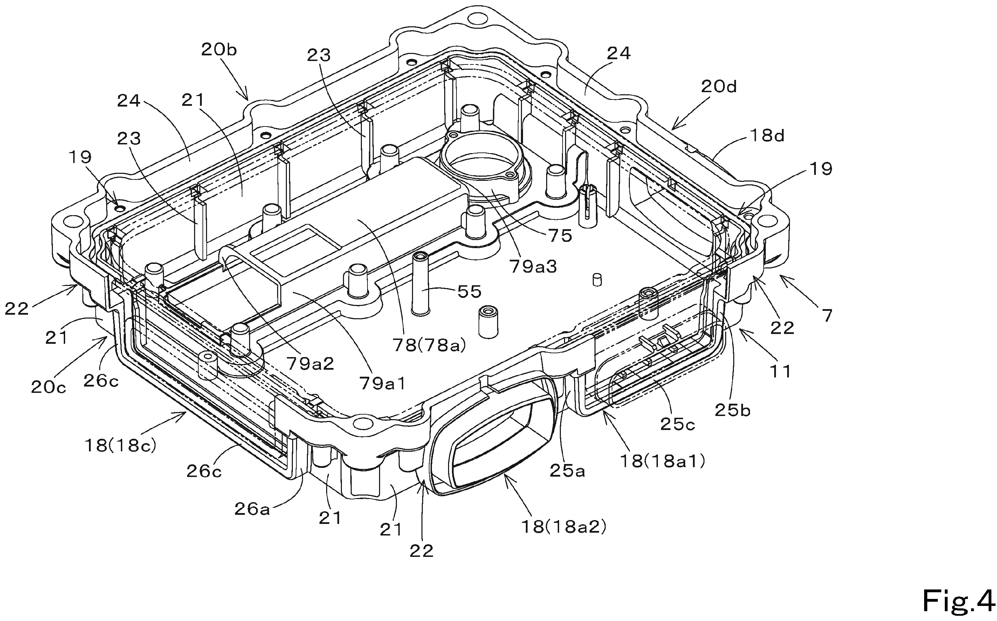

As shown in FIGS. 2 to 6, the first vertical wall 20a, the second vertical wall 20b, the third vertical wall 20c, and the fourth vertical wall 20d each include an upright portion 21 having an edge joined to the horizontal wall 10, and an outward projecting portion 22. A plurality of vertical support portions 23 are provided on an inner side (inner surface) of each upright portion 21. The outward projecting portion 22 projects from the upright portion 21 in the case-outward direction perpendicular to the toward-lid direction. Edge portion(s) 24 extending in the toward-lid direction is/are joined to the outward projecting portions 22, and the receiving portion(s) 19 is/are defined by the outward projecting portions 22 and the edge portion(s) 24.

As shown in FIGS. 1 to 6, the peripheral wall 11 includes a plurality of connector-receiving portions 18. Each of the plurality of the connector-receiving portions 18 is configured to have a connector 5 attached thereto. The connector 5 is configured to allow electricity to flow to the electronic substrate 2, and is a portion for input and output of signals. Note that examples of the connector 5 include a fixed connector attached directly or indirectly to the electronic substrate 2 and an attachable connector detachably connected externally to the fixed connector. The fixed connector and the attachable connector may each be simply referred to as "connector". In the present example embodiment, connector-receiving portion(s) 18 is/are provided on each of the first vertical wall 20a, the third vertical wall 20c, and the fourth vertical wall 20d. The first vertical wall 20a is provided with two connector-receiving portions 18a1 and 18a2, the third vertical wall 20c is provided with one connector-receiving portion 18c, and the fourth vertical wall 20d is provided with one connector-receiving portion 18d.

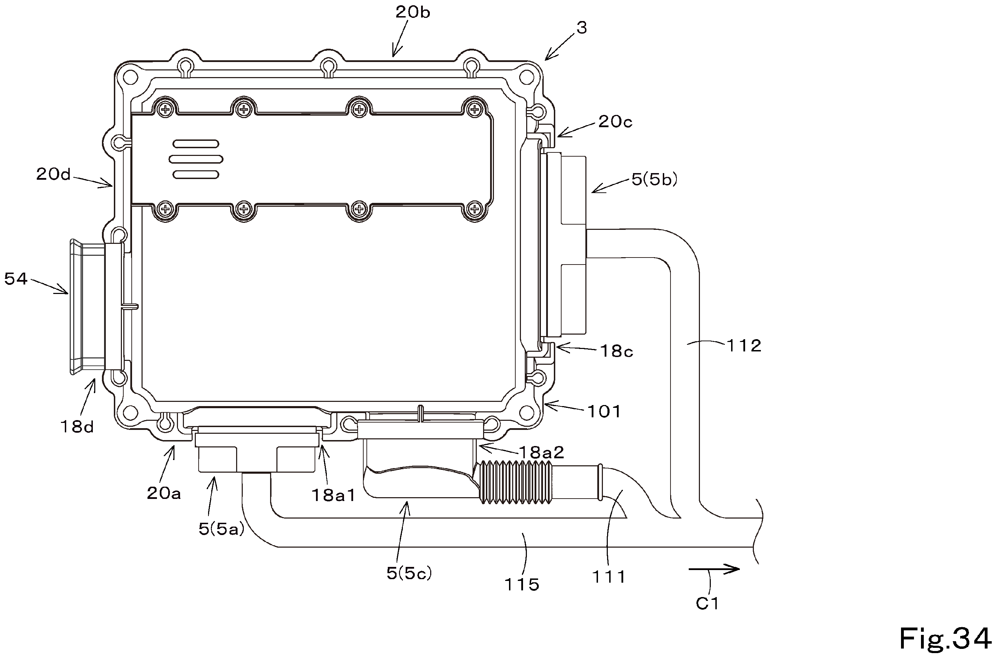

As shown in FIGS. 34 to 38, the connector-receiving portion 18a1 is configured to have a first connector 5a attached thereto, the connector-receiving portion 18a2 is configured to have a third connector 5c attached thereto, the connector-receiving portion 18c is configured to have a second connector 5b attached thereto, and the connector-receiving portion 18d is configured to have a fourth connector 5d attached thereto. Note that, in the case where one or more of the plurality of connector-receiving portions 18 have no connectors 5 attached thereto (such a connector-receiving portion with no connectors attached thereto may be referred to as "unoccupied (or empty or free) connector-receiving portion"), cover(s) 60 is/are attached to such connector-receiving portion(s).

The connector-receiving portion 18a1 is defined by a portion of the outward projecting portion 22 of the first vertical wall 20a that projects in a U shape. The connector-receiving portion 18a2 is defined by a portion of the outward projecting portion 22 of the first vertical wall 20a that projects in a tubular shape.

The connector-receiving portion 18c is defined by a portion of the outward projecting portion 22 of the third vertical wall 20c that projects in a U shape. The connector-receiving portion 18d is defined by a portion of the outward projecting portion 22 of the fourth vertical wall 20d that projects in a tubular shape.

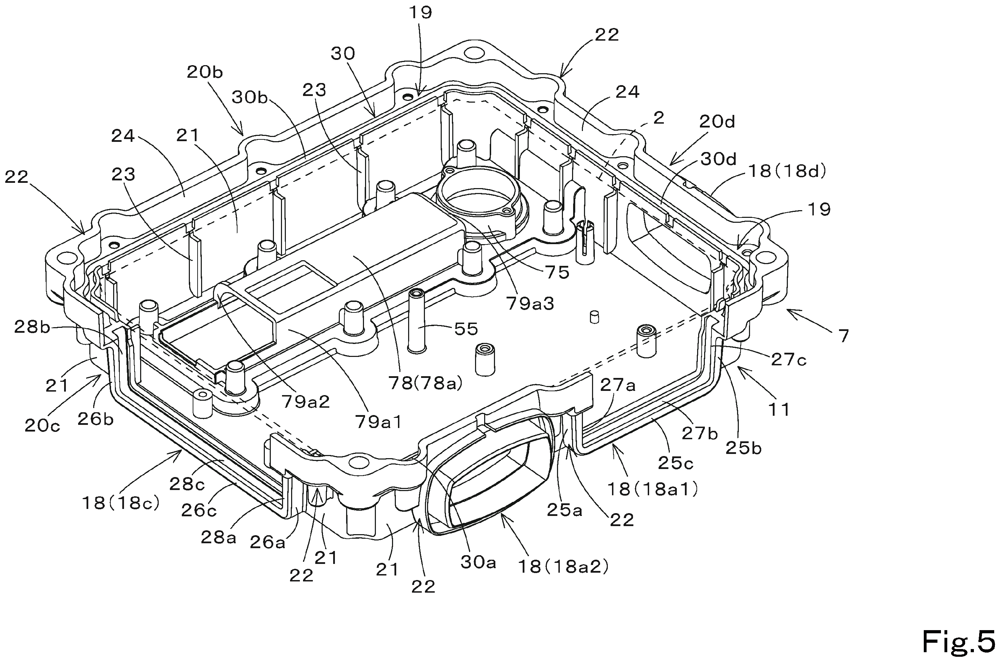

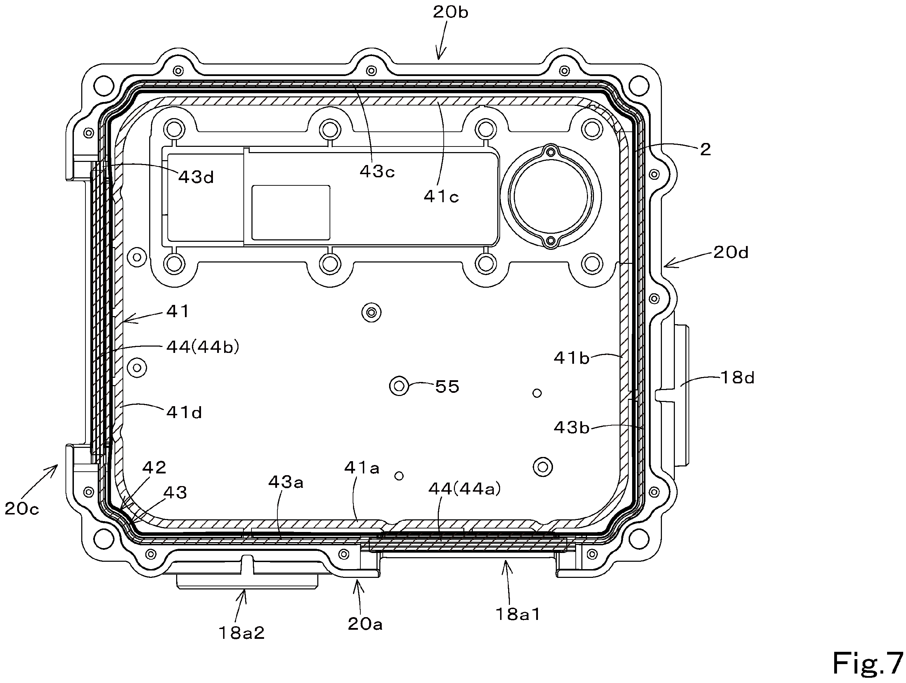

As shown in FIGS. 5 to 10, the connector-receiving portion 18a1 includes a first abutting portion 25a, a second abutting portion 25b, and a third abutting portion 25c. The first abutting portion 25a and the second abutting portion 25b each extend in a vertical direction, and the third abutting portion 25c extends in the horizontal direction. The first abutting portion 25a and the second abutting portion 25b are spaced apart from each other, and the third abutting portion 25c joins the first abutting portion 25a and the second abutting portion 25b. The first abutting portion 25a, the second abutting portion 25b, and the third abutting portion 25c include seal grooves 27a, 27b and 27c.

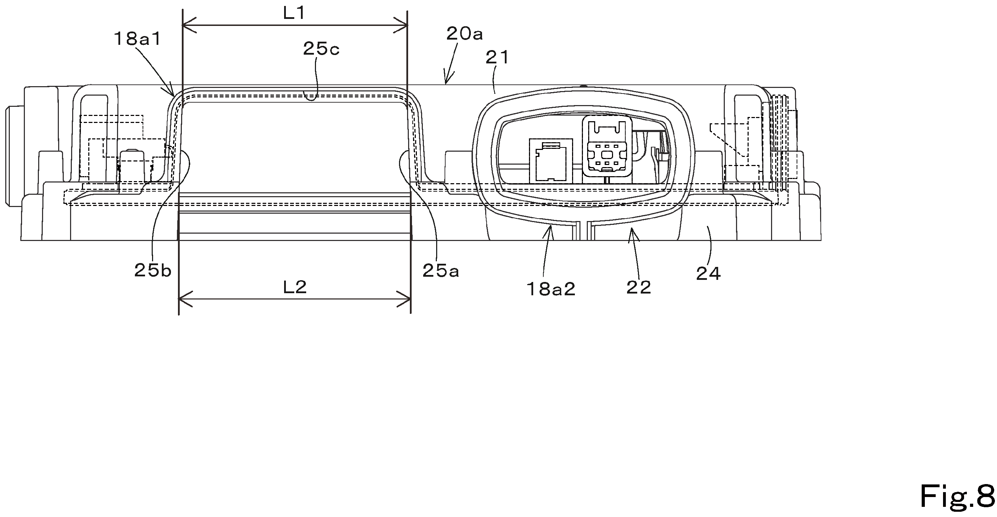

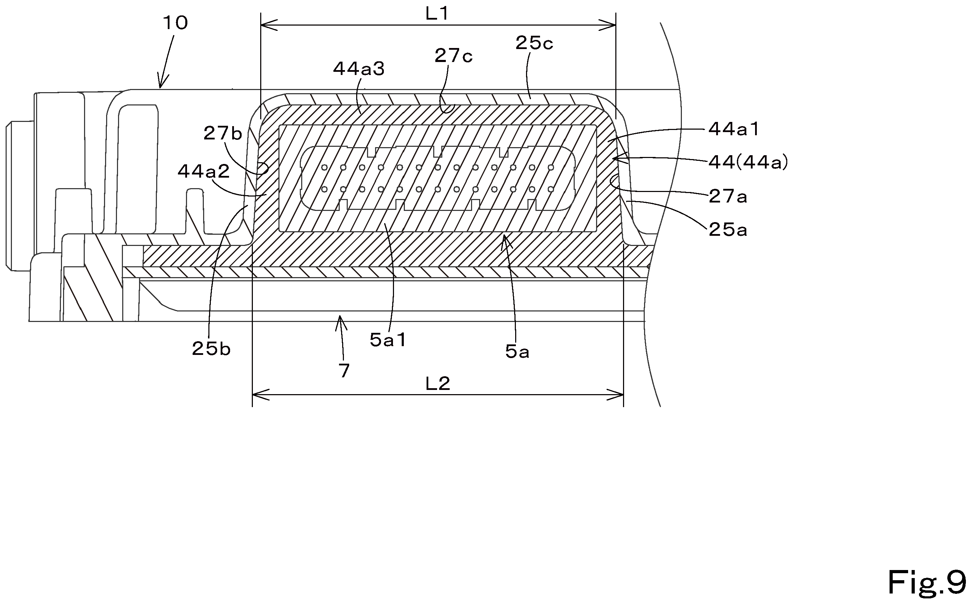

As shown in FIGS. 8 and 9, the first abutting portion 25a and the second abutting portion 25b are inclined such that they gradually approach each other with increasing distance from the lid body 7 and with decreasing distance to the horizontal wall 10. That is, a distance L1 between one end (lid-side end) of the first abutting portion 25a and one end (lid-side end) of the second abutting portion 25b is less than a distance L2 between the opposite end (the horizontal wall 10-side end) of the first abutting portion 25a and the opposite end (the horizontal wall 10-side end) of the second abutting portion 25b.

The connector-receiving portion 18c includes a first abutting portion 26a, a second abutting portion 26b, and a third abutting portion 26c. The first abutting portion 26a and the second abutting portion 26b each extend in the vertical direction, and the third abutting portion 26c extends in the horizontal direction. The first abutting portion 26a and the second abutting portion 26b are spaced apart from each other, and the third abutting portion 26c joins the first abutting portion 25a and the second abutting portion 25b. The first abutting portion 26a, the second abutting portion 26b, and the third abutting portion 26c include seal grooves 28a, 28b and 28c, respectively.

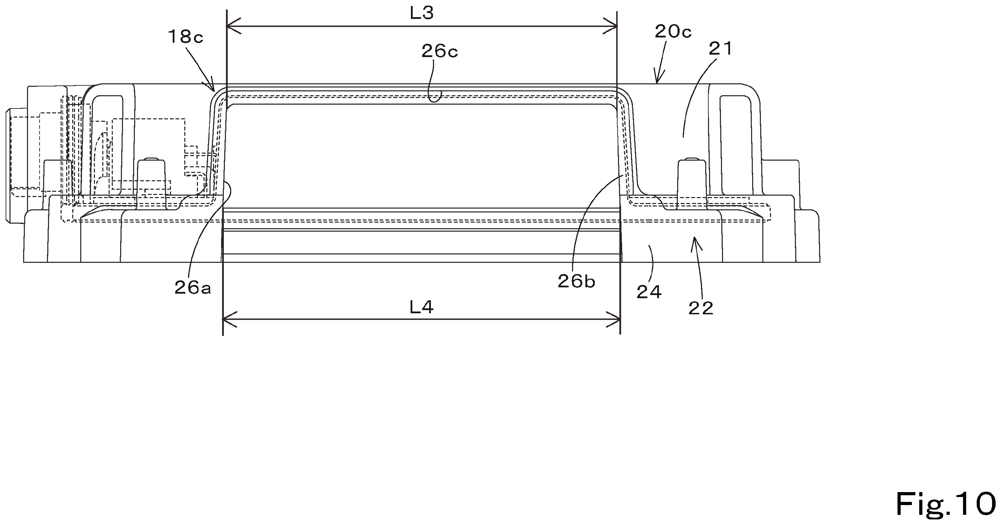

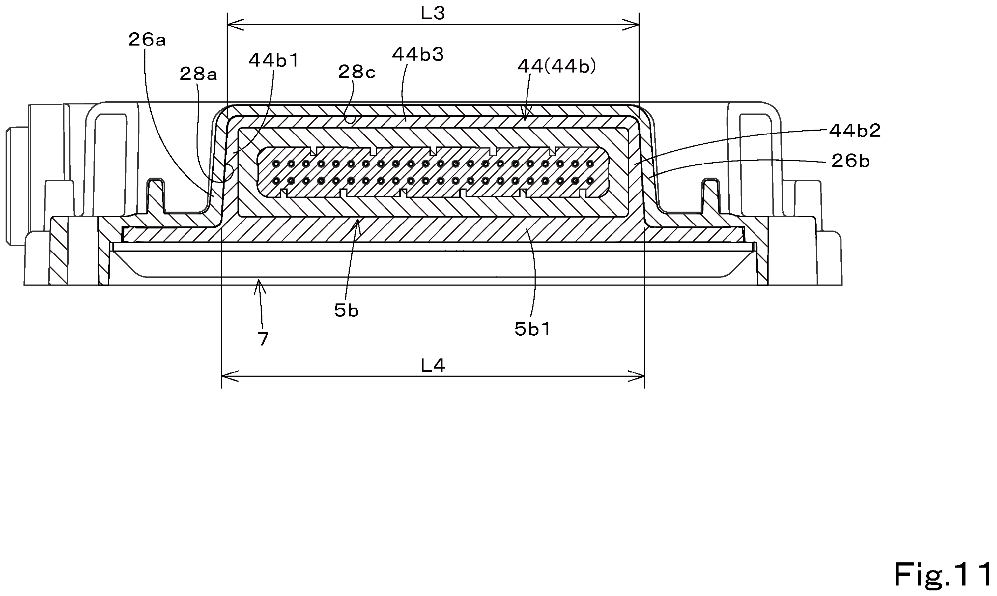

As shown in FIGS. 10 and 11, the first abutting portion 26a and the second abutting portion 26b are inclined such that they gradually approach each other with increasing distance from the lid body 7 and with decreasing distance to the horizontal wall 10. That is, a distance L3 between one end (lid-side end) of the first abutting portion 26a and one end (lid-side end) of the second abutting portion 26b is less than a distance L4 between the opposite end (horizontal wall 10-side end) of the first abutting portion 26a and the opposite end (horizontal wall 10-side end) of the second abutting portion 26b.

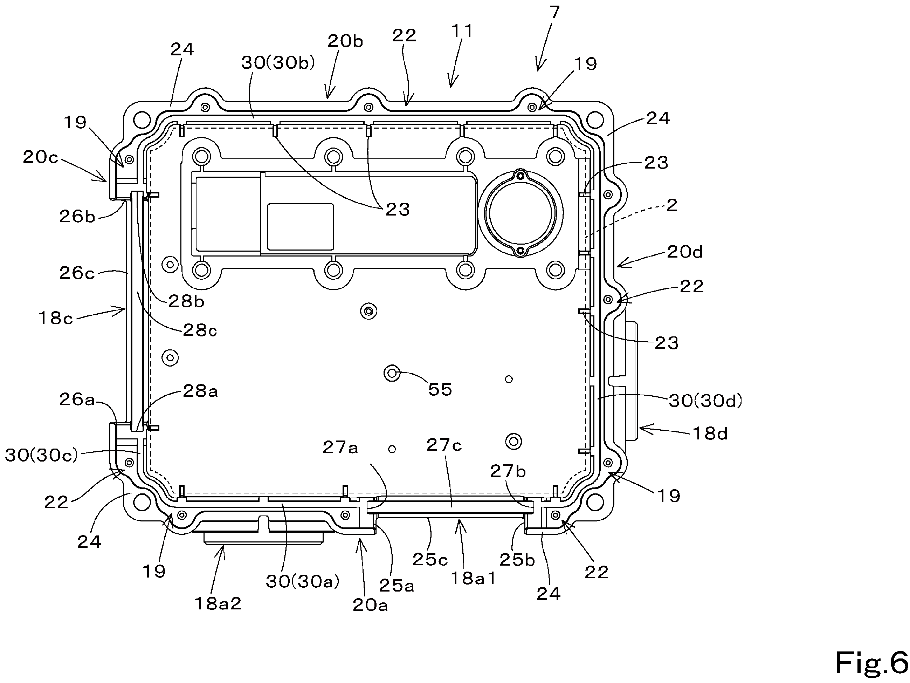

As shown in FIGS. 5 and 6, the peripheral wall 11 of the case body 6 includes a seal groove 30 in the inside thereof. The seal groove 30 is in the lid-side portion of the peripheral wall 11. The seal groove 30 extends over the first vertical wall 20a, the second vertical wall 20b, the third vertical wall 20c and the fourth vertical wall 20d. In the present example embodiment, the seal groove 30 is a recess in inner surfaces of the upright portions 21 or the outward projecting portions 22 of the first vertical wall 20a, the second vertical wall 20b, the third vertical wall 20c, and the fourth vertical wall 20d. The first vertical wall 20a, the second vertical wall 20b, the third vertical wall 20c and the fourth vertical wall 20d each have hole(s) 9 located outward of the seal groove 30 in the case-outward direction.

As shown in FIG. 6, the seal grooves 27a, 27b and 27c in the connector-receiving portion 18a1 (first abutting portion 25a, second abutting 25b and third abutting portion 25c) are located on an extension of the seal groove 30 in plan view. The seal grooves 28a, 28b and 28c in the connector-receiving portion 18c (first abutting portion 26a, second abutting portion 26b and third abutting portion 26c) are located on an extension of the seal groove 30 in plan view.

As described above, the case body 6 includes the seal grooves 27a, 27b, 27c, 28a, 28b, 28c and 30. The seal grooves 27a, 27b, 27c, 28a, 28b, 28c and 30 are configured to receive a seal member 40 (described later).

As shown in FIG. 1, the electronic device 1 includes a seal member 40 located between the case body 6 and the lid body 7. The seal member 40 is made from an elastic material such as rubber and configured to deform when pressed. The seal member 40 includes a first seal portion 41 and a second seal portion 42.

As shown in FIGS. 1, 4, 7, 14 and 15, the first seal portion 41 is a member configured to contact the electronic substrate 2. The first seal portion 41 contacts the electronic substrate 2 when the lid body 7 is attached to the case body 6.

The first seal portion 41 has a rectangular shape in cross section, and extends in an annular manner along edges 2a to 2d of the electronic substrate 2. The seal portion 41 includes a first extension portion 41a extending along the edge 2a, a second extension portion 41b extending along the edge 2b, a third extension portion 41c extending along the edge 2c, and a fourth extension portion 41d extending along the edge 2d.

The second seal portion 42 is located outward of the electronic substrate 2 and extends in an annular manner along the first seal portion 41, and is configured to contact the case body 6 and the lid body 7 when the lid body 7 is attached to the case body 6. The second seal portion 42 is fitted in a groove (seal groove 30) in the case body 6.

The second seal portion 42 is located outward of the first seal portion 41. The second seal portion 42 includes an annular portion 43 and a plurality of connector seal portions 44. The annular portion 43 and the plurality of connector seal portions 44 are integral with each other.

The annular portion 43 has a rectangular shape in cross section, is located outward of the electronic substrate 2, and extends along the edges 2a to 2d of the electronic substrate 2. The annular portion 43 includes a first extension portion 43a extending along the edge 2a, a second extension portion 43b extending along the edge 2b, a third extension portion 43c extending along the edge 2c and a fourth extension portion 43d extending along the edge 2d. In other words, the annular portion 43 of the second seal portion 42 extends along the first seal portion 41. The first extension portion 43a extends along the first extension portion 41a, the second extension portion 43b extends along the second extension portion 41b, the extension portion 43c extends along the third extension portion 41c, and the fourth extension portion 43d extends along the fourth extension portion 41d.

The annular portion 43 is fitted in a seal groove 30a in the first vertical wall 20a, a seal groove 30b in the second vertical wall 20b, a seal groove 30c in the third vertical wall 20c, and a seal groove 30d in the fourth vertical wall 20d.

The plurality of connector seal portions 44 include a first connector seal portion 44a and a second connector seal portion 44b. The first connector seal portion 44a is joined to the annular portion 43 and positioned at the connector-receiving portion 18a1. The second connector seal portion 44b is joined to the annular portion 43 and provided at the connector-receiving portion 18c.

As shown in FIG. 1, the first connector seal portion 44a is a rectangular elastic member and is joined to the first extension portion 43a. The first connector seal portion 44a includes an insertion portion 46 for insertion of the first connector 5a. The first connector seal portion 44a includes a first opposing portion 44a1 to face the first abutting portion 25a, a second opposing portion 44a2 to face the second abutting portion 25b, and a third opposing portion 44a3 to face the third abutting portion 25c. As shown in FIG. 9, the first opposing portion 44a1, the second opposing portion 44a2, and the third opposing portion 44a3 can be fitted in the seal grooves 27a, 27b and 27c, respectively.

An attached portion 5a1 of the first connector 5a is inserted in the insertion portion 46, and the first connector seal portion 44a is fitted in the seal grooves 27a, 27b and 27c in the connector-receiving portion 18a1, so that sealing at a periphery of the first connector 5a is achieved by the first connector seal portion 44a.

As shown in FIG. 1, the second connector seal portion 44b is a rectangular elastic member and is joined to the fourth extension portion 43d. The second connector seal portion 44b includes an insertion portion 47 for insertion of the second connector 5b. The second connector seal portion 44b includes a first opposing portion 44b1 to face the first abutting portion 26a, a second opposing portion 44b2 to face the second abutting portion 26b, and a third opposing portion 44b3 to face the third abutting portion 26c. As shown in FIG. 11, the first opposing portion 44b1, the second opposing portion 44b2, and the third opposing portion 44b3 can be fitted in the seal grooves 28a, 28b and 28c, respectively.

An attached portion 5b1 of the second connector 5b is inserted in the insertion portion 47, and the second connector seal portion 44b is fitted in the seal grooves 28a, 28b and 28c in the connector-receiving portion 18b1, so that sealing at a periphery of the second connector 5b is achieved by the second connector seal portion 44b.

As shown in FIG. 1, the seal member 40 includes joining portion(s) 45 to join the first seal portion 41 and the second seal portion 42. The joining portion(s) 45 join(s) the first extension portion 41a and the first extension portion 43a. The joining portion(s) 45 join(s) the second extension portion 41b and the second extension portion 43b. The joining portion(s) 45 join(s) the third extension portion 41c and the third extension portion 43c. The joining portion(s) 45 join(s) the fourth extension portion 41d and the fourth extension portion 43d.

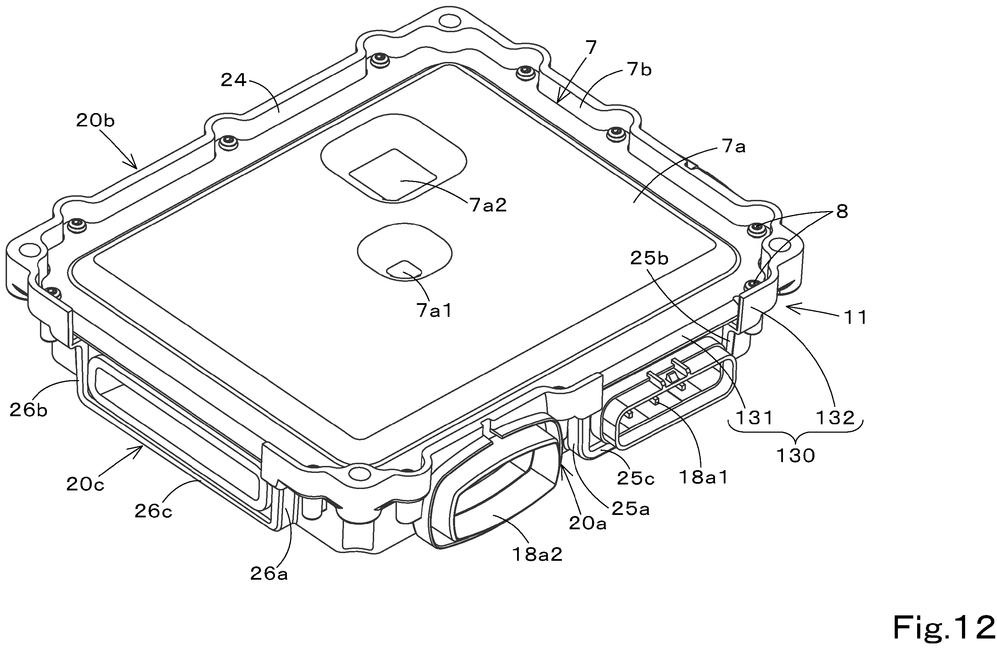

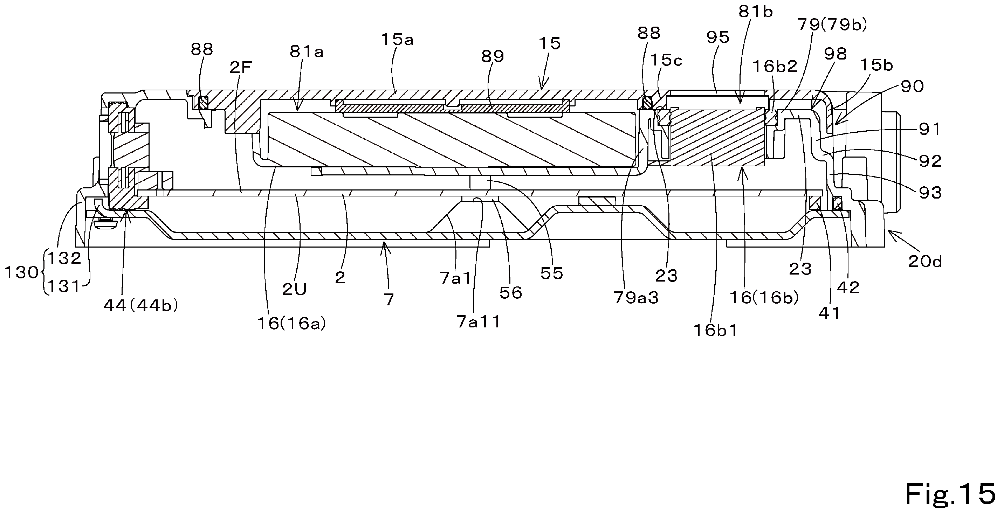

The housing 3 includes a guard portion 130 to guard (or protect) the connector seal portion 44. As shown in FIGS. 12 and 15, the guard portion 130 includes a first guard 131 and a second guard 132. The first guard 131 is located in the vicinity of the connector-receiving portion 18. The first guard 131 is an edge portion of a flange portion 7b that is bent toward the connector-receiving portion 18 and that overlaps the lid body 7-side portion of the connector seal portion 44. The guard 132 is a portion of the edge 24 of the outward projecting portion 22 that overlaps the edge portion (first guard 131) of the flange portion 7b.

As shown in FIGS. 1 and 12, the lid body 7 has a plate shape. The sides of the lid body 7 are longer than the respective sides of the electronic substrate 2. The lid body 7 includes a plate portion 7a that has a rectangular shape in plan view, and the flange portion 7b provided at a periphery of the plate portion 7a. The plate portion 7a includes a first projecting portion 7a1 that projects in the case-inward direction and a second projecting portion 7a2 that projects in the case-inward direction and spaced apart from the first projecting portion 7a1. The first projecting portion 7a1 includes a flat surface 7a11 in which a portion of the first projecting portion 7a1 that is located in the interior of the case is flat. The flange portion 7b has a plurality of the holes 9. When the lid body 7 is aligned with the case body 6, edges of the lid body 7 are located at the receiving portion(s) 19.

As shown in FIGS. 1, 4, 5, 7, 14 and 15, the case body 6 includes a rod body 55. The rod body 55 extends from the case body 6 toward the lid body 7, and supports the electronic substrate 2 independently of the vertical support portions 23. The lid body 7 is a tubular body extending from an inner surface of the flat portion 13 of the horizontal wall 10 toward the first projecting portion 7a1. The tubular body includes a flat end.

As shown in FIG. 1 and FIGS. 5 to 7, when the electronic substrate 2 is fitted in the case body 6, the attached portion 5a1 of the first connector 5a is inserted in the insertion portion 46 of the first connector seal portion 44a, and the attached portion 5b1 of the second connector 5b is inserted in the insertion portion 47 of the second connector seal portion 44b. The first seal portion 41 of the seal member 40 abuts a second face (a second surface facing toward the lid body 7) 2U of the electronic substrate 2.

The first connector seal portion 44a is then fitted in the connector-receiving portion 18a1 and the second connector seal portion 44b is fitted in the connector-receiving portion 18c, with the first connector seal portion 44a and the second connector seal portion 44b attached to the periphery of the first connector 5a and the periphery of the second connector 5b, respectively. As shown in FIGS. 8 and 9, since the distance (dimension) L1 of the connector-receiving portion 18a1 is shorter than the distance (dimension) L2, edge portions (first opposing portion 44a1, second opposing portion 44a2 and third opposing portion 44a3) of the first connector seal portion 44a deform while being fitted in the seal grooves 27a, 27b and 27c, and edge portions (first opposing portion 44b1, second opposing portion 44b2 and third opposing portion 44b3) of the second connector seal portion 44b deform while being fitted in the seal grooves 28a, 28b and 28c, thus achieving the sealing property to seal the first connector 5a and the second connector 5b.

As shown in FIG. 1 and FIGS. 5 to 7, when the electronic substrate 2 is fitted in the case body 6, the annular portion 43 of the second seal portion 42 is fitted in the seal grooves 30a, 30b, 30c and 30d. A first face (first surface facing toward the horizontal wall 10) 2F of the electronic substrate 2 is caused to contact the vertical support portions 23. The first surface 2F of the electronic substrate 2 is also caused to contact the end of the rod body 55.

The lid body 7 is fastened to the case body 6 with the first seal portion 41 abutting the second face (second surface facing toward the lid body 7) 2U of the electronic substrate 2 and a cushioning material 56 attached to the flat surface 7a11.

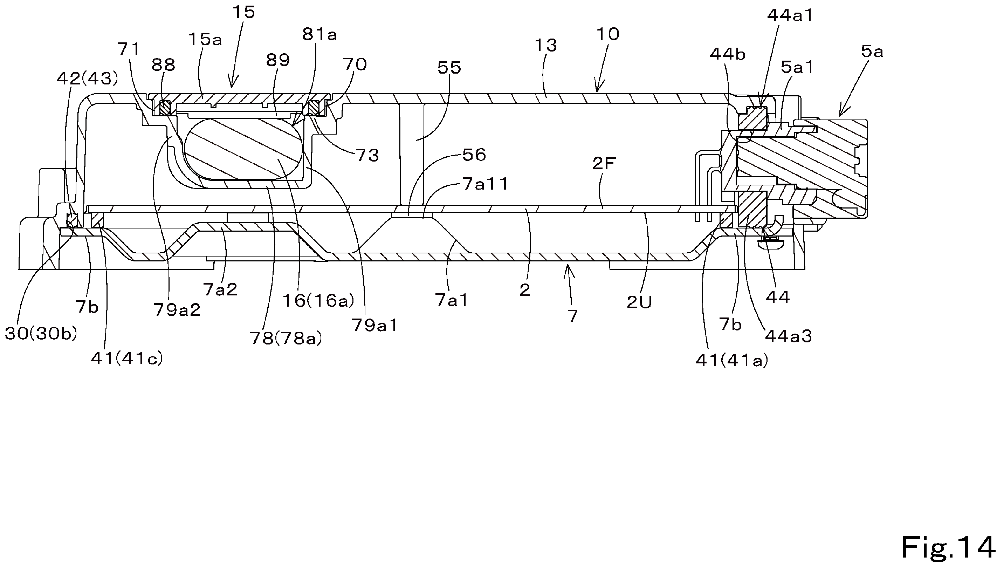

As described above, once the lid body 7 is fastened to the case body 6, the edge portions of the electronic substrate 2 are supported by the vertical support portions 23 and, as shown in FIGS. 14 and 15, the central portion and/or the vicinity of the central portion of the electronic substrate 2 is supported by the rod body 55. The first seal portion 41 and the second seal portion 42 of the seal member 40 are pressed by the flange portion 7b. The annular portion 43 of the second seal portion 42 deforms within the seal grooves 30a, 30b, 30c and 30d, thus achieving sealing property.

Thus, the electronic substrate 2 can be fixed (secured, attached) to the housing 3 by being sandwiched (or held) between the lid body 7 and the case body 6.

Note that, when the electronic substrate 2 is not supported in the housing 3 by being sandwiched between the lid body 7 and the case body 6, the housing 3 does not need to include both the case body 6 and the lid body 7. It is only necessary that at least the housing 3 include a peripheral wall 11, a first wall (horizontal wall 10) provided on one of opposite sides in the height direction of the peripheral wall 11, and a second wall (portion corresponding to the lid body 7) provided at the other of the opposite sides in the height direction of the peripheral wall 11, and be configured such that an electronic substrate 2 is housed in a space defined by the peripheral wall 11, the first wall (horizontal wall 10), and the second wall (portion corresponding to the lid body 7).

The following describes the container portion 14.

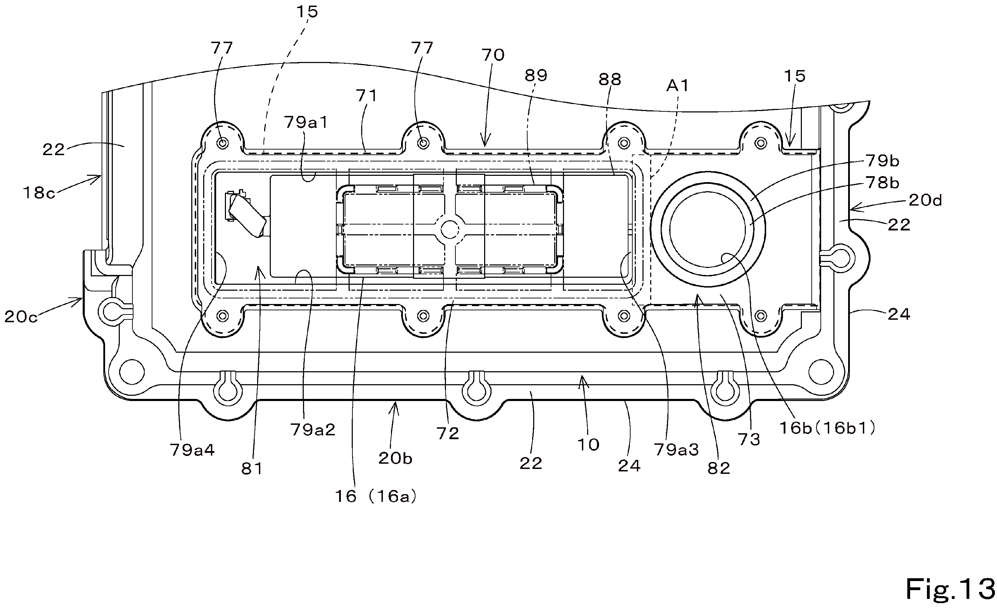

As shown in FIGS. 13 to 15, the container portion 14 includes a first container chamber 81 and a second container chamber 82.

The electric storage device 16a is housed in the first container chamber 81, and the electrical device 16b is housed in the second container chamber 82. The first container chamber 81 and the second container chamber 82 are configured to be divided into two chambers by the lid portion 15 (described later).

The container portion 14 includes a lid support portion 70 to support the lid portion 15. The lid support portion 70 includes a first mounting wall 71, a second mounting wall 72, and a third mounting wall 73. The first mounting wall 71 extends from the horizontal wall 10 in the case-inward direction, the second mounting wall 72 also extends from the horizontal wall 10 in the case-inward direction. The first mounting wall 71 and the second mounting wall 72 are spaced from each other, and the first mounting wall 71 and the second mounting wall 72 face each other (opposed to each other). The third mounting wall 73 joins the first mounting wall 71 and the second mounting wall 72.

The lid support portion 70 has a recessed shape defined by the first mounting wall 71, the second mounting wall 72, and the third mounting wall 73. The third mounting wall 73 includes a plurality of holes 77 for insertion of fasteners 76 such as bolts. For convenience of description, the lid support portion 70 may be referred to as "recessed portion 70". The lid support portion 70 (first mounting wall 71, second mounting wall 72 and third mounting wall 73) extends over the first container chamber 81 and the second container chamber 82.

The container portion 14 includes a plurality of side walls 79 and a plurality of placement walls 78. The plurality of side walls 79 include a side wall 79a provided at the first container chamber 81 and a side wall 79b provided at the second container chamber 82. The plurality of placement walls 78 include a placement wall 78a provided at the first container chamber 81 and a placement wall 78b provided at the second container chamber 82.

The side wall 79a extends from the lid support portion 70 (third mounting wall 73) in a direction away from the lid portion 15. The side wall 79a includes a first surface 79a1, a second surface 79a2, a third surface 79a3, and a fourth surface 79a4. The first surface 79a1 and the second surface 79a2 are opposed to (face) each other, and the third surface 79a3 and the fourth surface 79a4 are opposed to (face) each other. The third surface 79a3 joins an edge of the first surface 79a1 and an edge of the second surface 79a2, and the fourth surface 79a4 joins another edge of the first surface 79a1 and another edge of the second surface 79a2.

The placement wall 78a is a portion joined to the side wall 79a and is configured to allow the device 16 to be placed thereon. In the present example embodiment, the placement wall 78a is joined to the first surface 79a1, the second surface 79a2 and the third surface 79a3. Accordingly, with the side wall 79a and the placement wall 78a, the container portion 14 of the first container chamber 81 has a box shape having an open side facing toward the lid portion 15, i.e., has a recessed shape, to house the rectangular electric storage device 16a.

The side wall 79b extends from the lid support portion 70 (third mounting wall 73) in a direction away from the lid portion 15 and has a tubular shape. The placement wall 78b projects from the side wall 79b in a radially inward direction and has a circular shape. A tubular support body 75 is joined to a radially inner periphery of the placement wall 78b. Accordingly, with the side wall 79a and the placement wall 78a, the container portion 14 of the second container chamber 82 has a tubular shape having an open side facing toward the lid portion 15, to house the cylindrical electrical device 16b. Specifically, the electrical device 16b includes a cylindrical main body 16b1 and a seal member 16b2 to be attached to the main body 16b1. The electrical device 16b is supported by the seal member 16b2 being fitted in a space defined by the side wall 79b and the placement wall 78b.

The lid portion 15 is a member to cover the first container chamber 81 and the second container chamber 82. The lid portion 15 has a sheet shape along the lid support portion 70 in plan view, and is attachable to (can be fitted in) the lid support portion 70. The lid portion 15 includes a first plate portion 15a opposed to (facing) the third mounting wall 73 and a second plate portion 15b extending from the first plate portion 15a along the peripheral wall 11. That is, the second plate portion 15b faces the fourth vertical wall 20d and overlaps the fourth vertical wall 20d such that they both extend in the vertical direction.

An inner surface of the lid portion 15 has thereon projection portions 15c and 15d extending from the lid portion 15. Accordingly, since the projecting portions 15c and 15d abut the third mounting wall 73 when the lid portion 15 is fitted in the lid support portion 70, the lid portion 15 is fitted between the first mounting wall 71 and the second mounting wall 72 such that the lid portion 15 is separate from the third mounting wall 73.

It is noted here that, as shown in FIGS. 13 and 15, in plan view, the third surface 79a3 of the side wall 79a and the side wall 79b are spaced from each other in the horizontal direction. That is, a portion of the third mounting wall 73 that is between the third surface 79a3 and the side wall 79b is a portion (partitioning area A1) to separate the first container chamber 81 and the second container chamber 82 from each other. When the lid portion 15 is attached to the lid support portion 70, the projecting portion 15c abuts the partitioning area of the third mounting wall 73, so that the projecting portion 15c functions as a partitioning portion to separate the first container chamber 81 and the second container chamber 82 from each other. The projecting portion 15c also functions to support the electrical device because the projecting portion 15c presses the seal member 16b2 attached to the main body 16b1.

A first waterproof member 88 is provided at the inner surface of the lid portion 15 such that the first waterproof member 88 is on the same side of the projecting portion 15c (partitioning portion) as the first container chamber 81. The first waterproof member 88 has an annular shape, and is, in plan view, located outward of the side wall 79a of the first container chamber 81. The first waterproof member 88 contacts at least the partitioning area A1 of the third mounting wall 73. A second waterproof member 89 to contact the electric storage device 16a is located at the lid portion 15 separately from the first waterproof member 88. The second waterproof member 89 has an annular shape, and is, in plan view, smaller than the first waterproof member 88. Thus, the first container chamber 81 is protected against water by two waterproof members (first waterproof member 88 and second waterproof member 89).

Note that the housing 3 includes a discharging structure 90 to allow foreign matter in the container portion 14 to escape (or to be discharged) from the container portion 14. Foreign matter includes sludge, water, dust and/or the like. In particular, the discharging structure 90 is configured to allow sludge containing moisture and water to escape. The discharging structure 90 is configured to allow foreign matter to escape from the container portion 14 to an area outside a first wall (horizontal wall 10) and allow foreign matter to escape from the container portion 14 to an area outside the peripheral wall 11. That is, the discharging structure 90 is configured to allow foreign matter to escape both to the area outside the horizontal wall 10 and the area outside the peripheral wall 11.

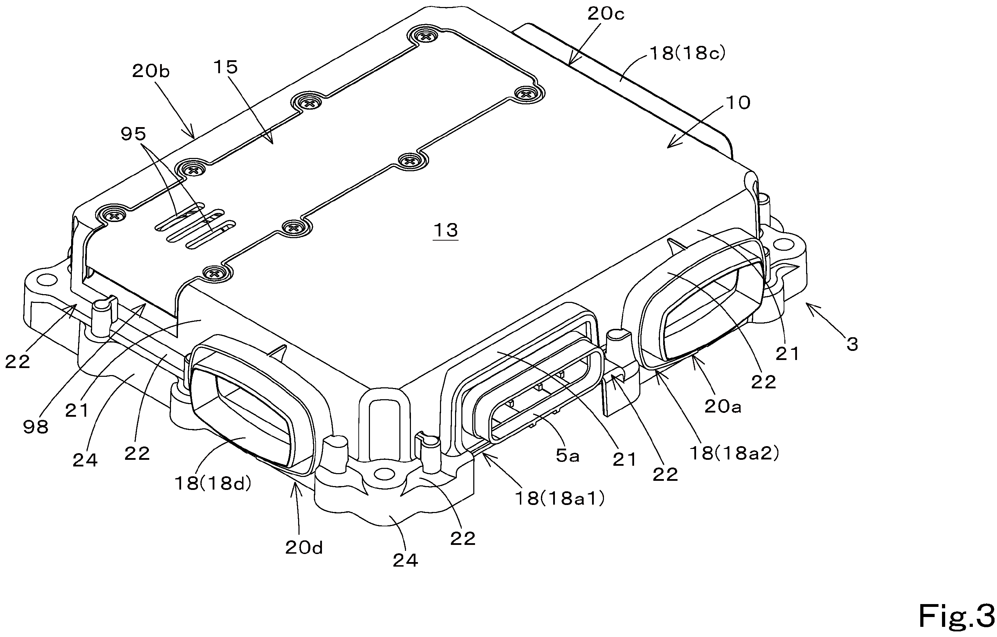

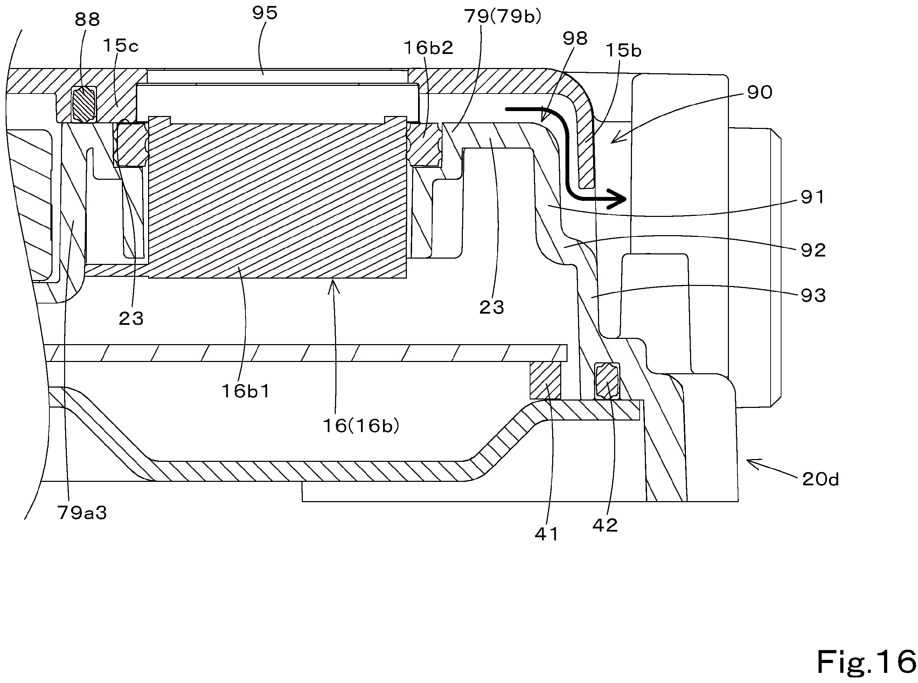

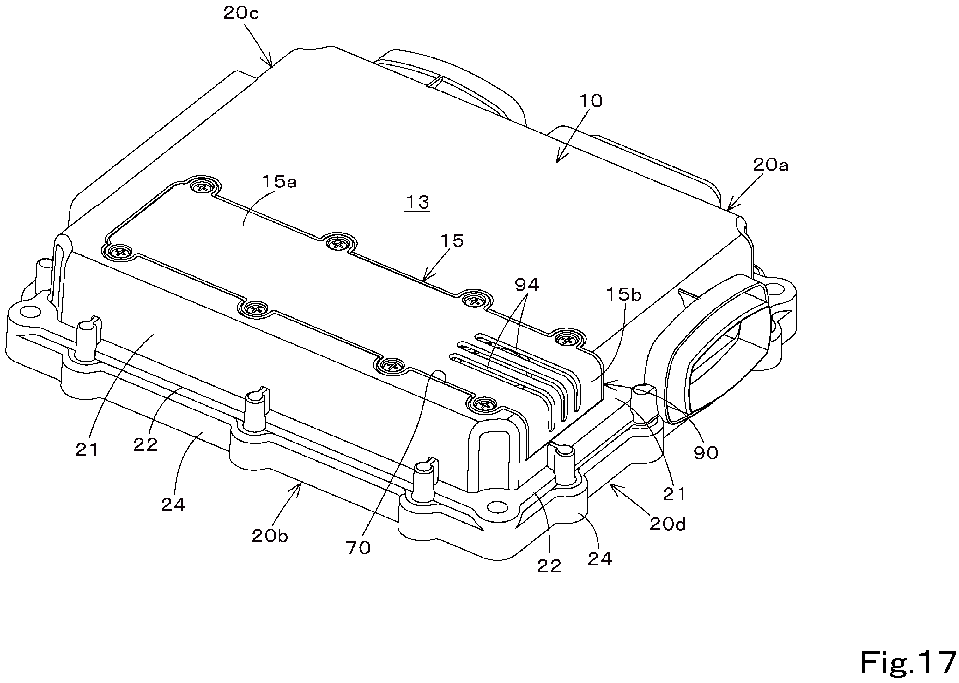

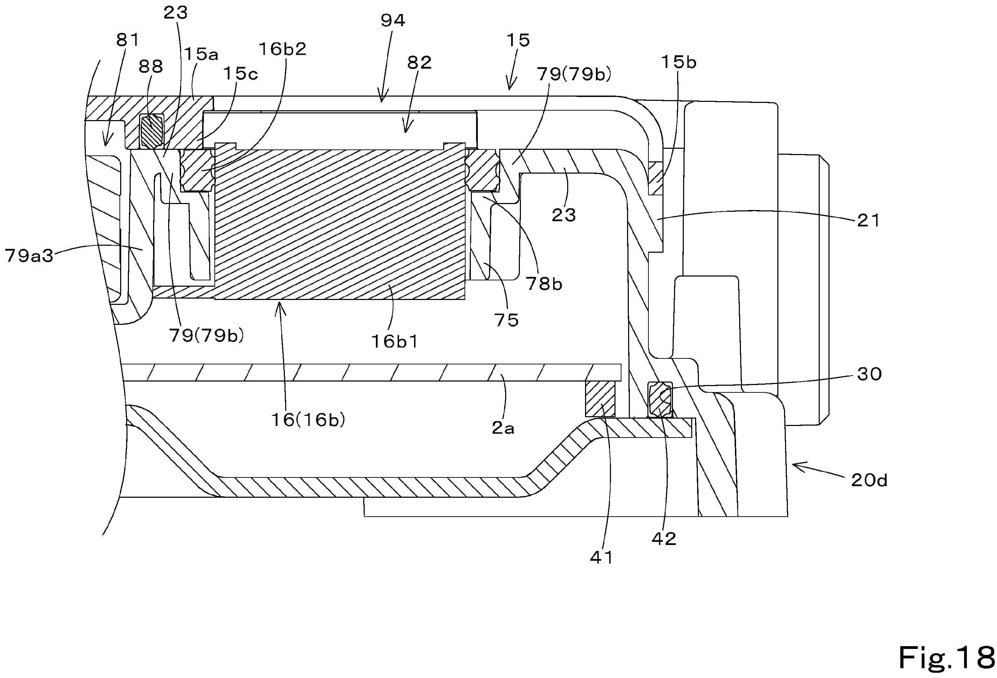

FIGS. 3, 15 and 16 illustrate an example of the discharging structure 90, and FIGS. 17 and 18 illustrate a variation of the discharging structure 90.

The discharging structure 90 shown in FIGS. 3, 15 and 16 includes a communication path 98 through which the area outside the peripheral wall 11 and the container portion 14 are in communication with each other, and through-hole(s) 95. The communication path 98 includes the recessed portion 70 that extends to the peripheral wall 11.

The communication path 98 is defined by (i) the fourth vertical wall 20d having a stepped shape, (ii) the horizontal wall 10-side edge of the fourth vertical wall 20d being joined to the third mounting wall 73 at the second container chamber 82, and (iii) the fourth vertical wall 20d and the second plate portion 15b being separate from each other. Specifically, the fourth vertical wall 20d includes a first section 91 that is joined to the third mounting wall 73 at the second container chamber 82 and extends toward the lid body 7 (second wall), a second section 92 that is joined to the first section 91 and bends in the horizontal direction at an intermediate portion thereof, and a third section 93 which is joined to the second section 92 and in which the lid body 7 (second wall) fits. The first section 91 and the second plate portion 15b are separate from each other, and foreign matter (drainage) and/or the like from the container portion 14 escapes toward the fourth vertical wall 20d (peripheral wall 11). The second through-holes 95 are provided in the lid portion 15. The second through-holes 95 pass through the first plate portion 15a but do not reach the second plate portion 15b. The second through-holes 95 are in communication with the second container chamber 82, and are holes through which the inside of the container portion 14 is in communication with the area outside the horizontal wall 10. With the discharging structure 90 shown in FIGS. 3, 15 and 16, the discharging structure 90 allows foreign matter to escape through the second through-holes 95 to the area outside the horizontal wall 10, and to allow foreign matter to escape through the communication path 98 to the area outside the fourth vertical wall 20d (area outside the peripheral wall 11).

The discharging structure 90 of FIGS. 17 and 18 includes first through-hole(s) 94. The first through-holes 94 are through-holes in the lid portion 15 through which the inside of the container portion 14 is in communication with the area outside the horizontal wall 10 and through which the container portion 14 is in communication with the area outside the peripheral wall 11. For example, the first through-holes 94 extend from the first plate portion 15a to the second plate portion 15b. The edge of the second plate portion 15b on the fourth vertical wall 20d side contacts the fourth vertical wall 20d, and closes the container portion 14 at the fourth vertical wall 20d side. With the discharging structure 90 of FIGS. 17 and 18, the discharging structure 90 allows foreign matter to escape through the first through-holes 94 to the area outside the horizontal wall 10 and the area outside the fourth vertical wall 20d (area outside the peripheral wall 11).

Note that, although the container portion 14 is provided at the horizontal wall (first wall) 10, the container portion 14 may be provided at a second wall opposed to (facing) the horizontal wall (first wall) 10, i.e., at a wall portion corresponding to the lid body 7. Also note that, although the discharging structure 90 is provided at the horizontal wall (first wall) 10, the discharging structure 90 may be provided at a second wall opposed to (facing) the horizontal wall (first wall) 10, i.e., at a wall portion corresponding to the lid body 7. In such a case, the first through-holes 94 are holes through which the inside of the container portion 14 is in communication with at least one of the area outside the first wall side or the area outside the second wall and through which the inside of the container portion 14 is in communication with the area outside the peripheral wall 11. The second through-holes 95 are holes through which the inside of the of the container portion 14 is in communication with at least one of the area outside the first wall or the area outside the second wall.

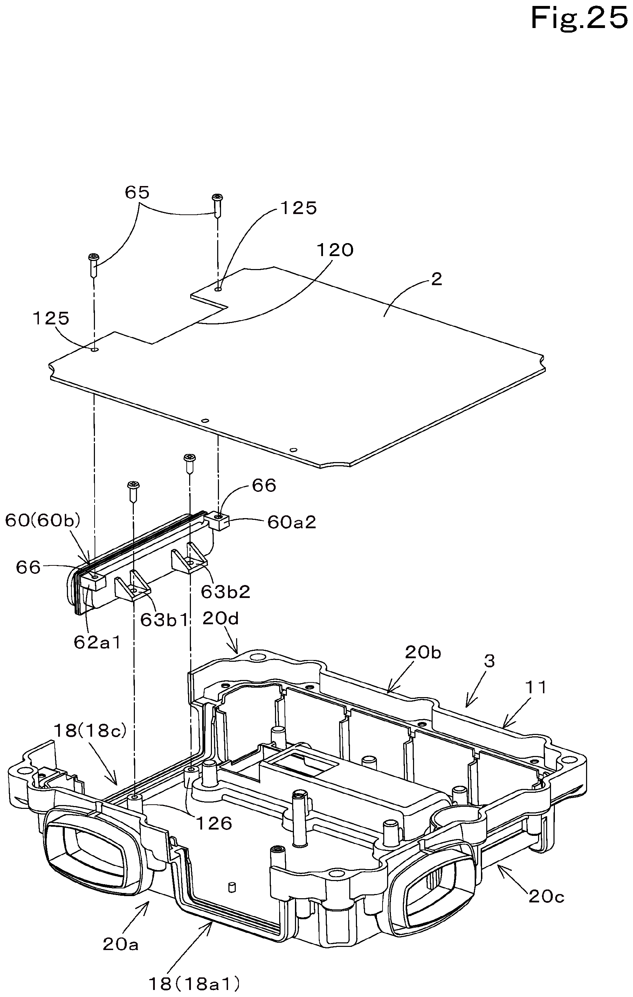

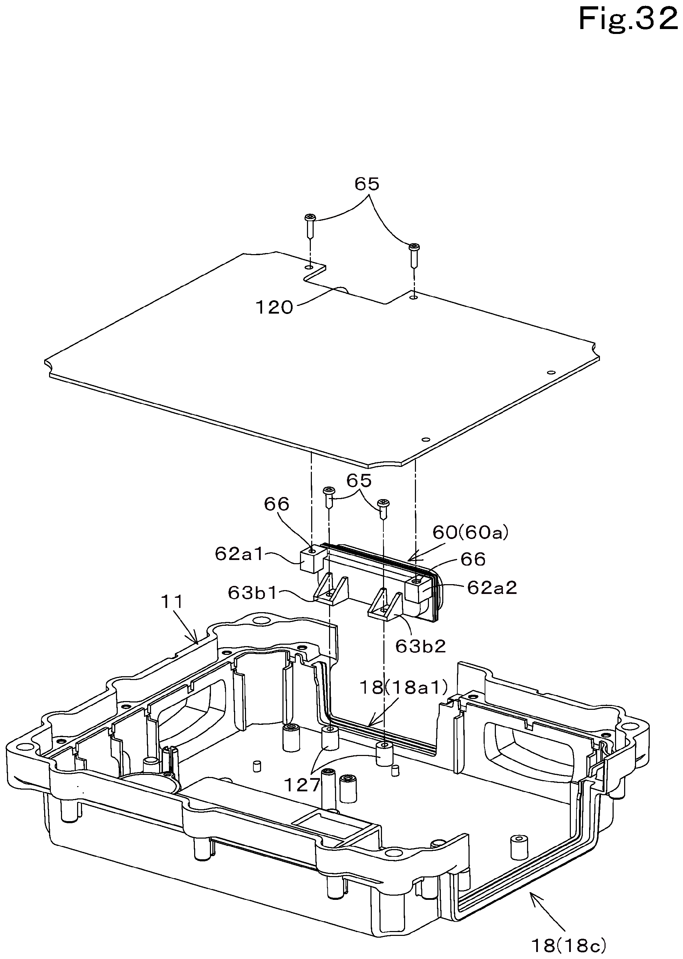

Note that, in the electronic device 1, there are cases where one or more of the plurality of connector-receiving portions 18 are not provided with the connector 5. As shown in FIGS. 25 and 32, it is possible to attach the cover(s) 60 to unoccupied connector-receiving portion(s) each of which is a connector-receiving portion 18 at which no connector 5 is located (no connector 5 is attached).

The following describes the cover(s) 60.

As shown in FIGS. 25 and 32, the covers 60 include a cover 60a to be attached to the electronic substrate 2 instead of the connector 5 attached to the electronic substrate 2, and a cover 60b to be attached instead of the second connector 5b. Since the cover 60a and the cover 60b have different sizes but have substantially the same structure, substantially the same structure will be described.

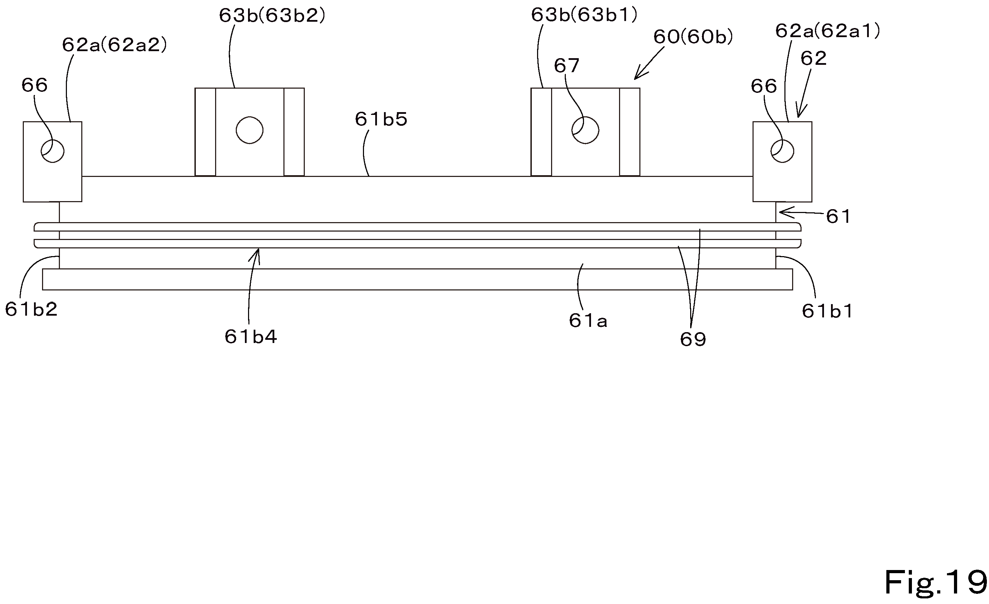

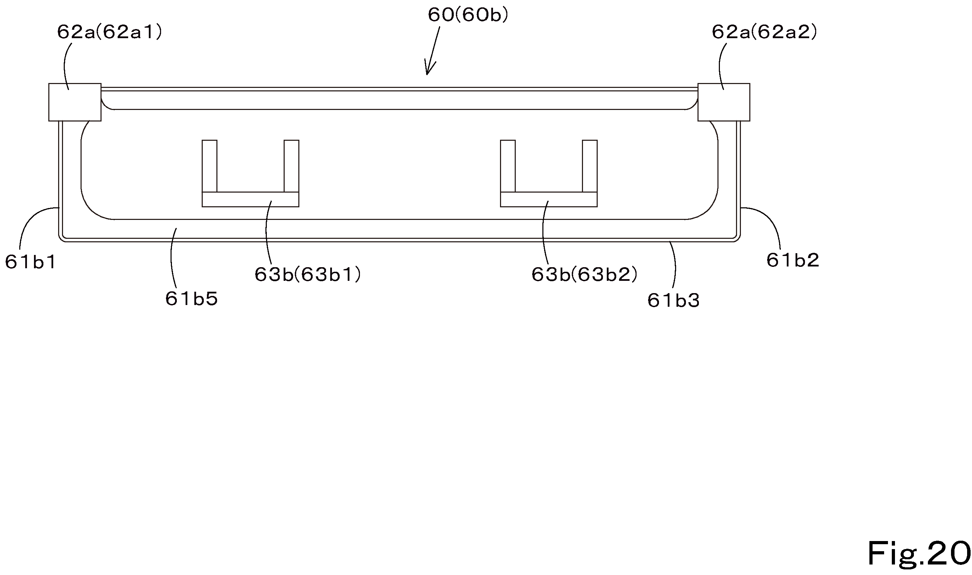

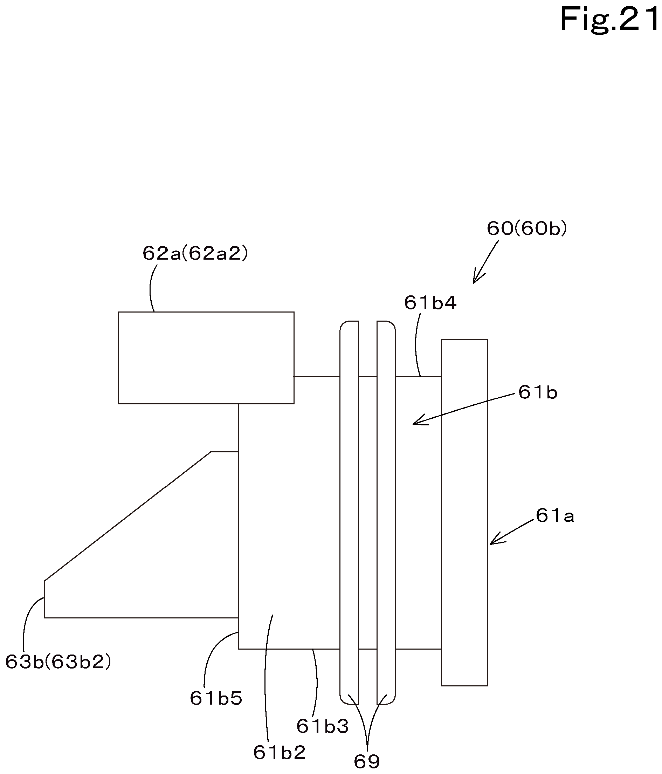

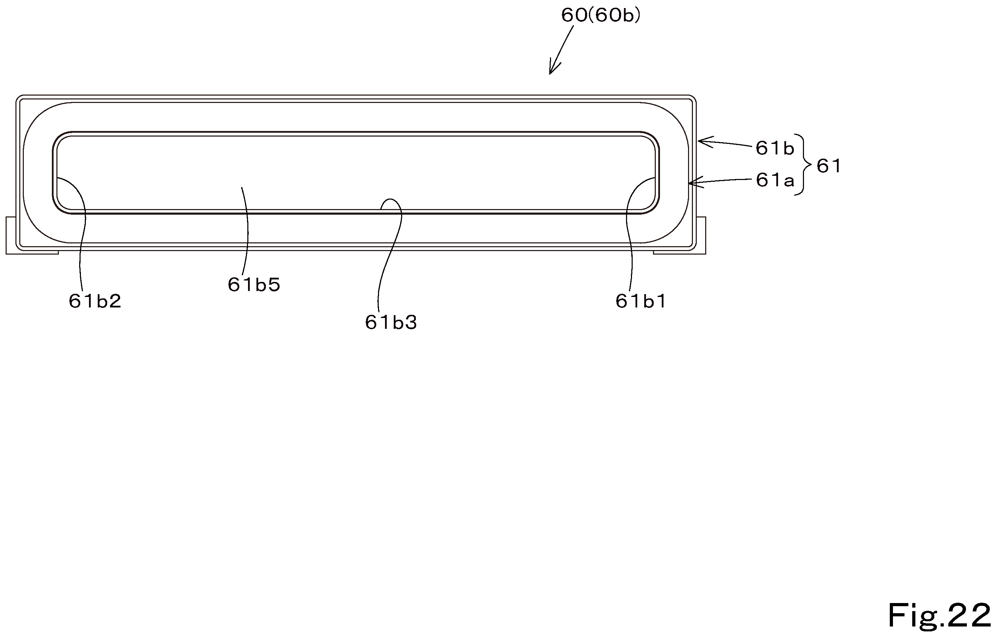

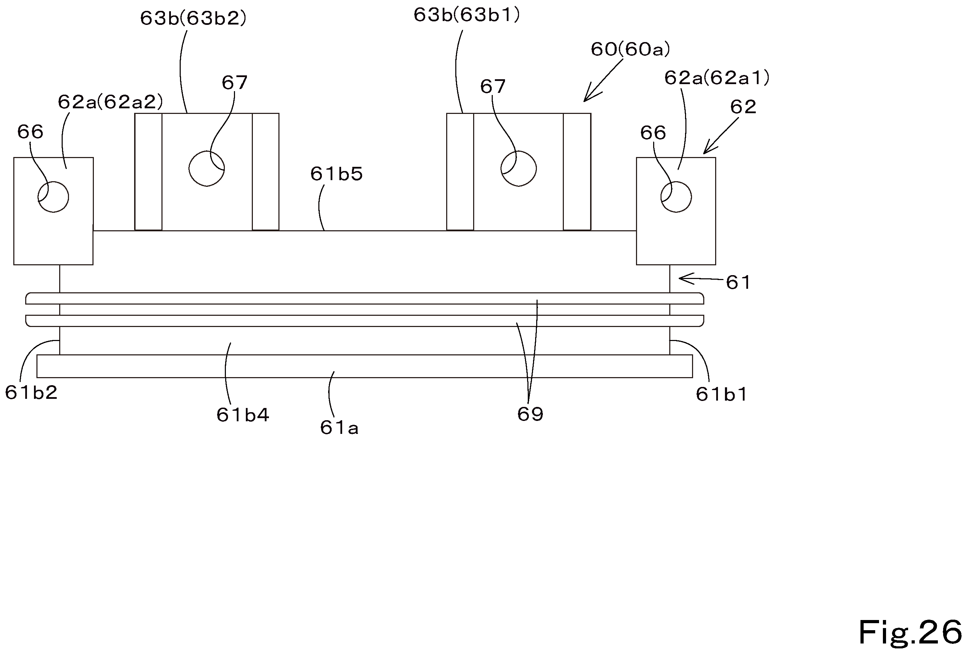

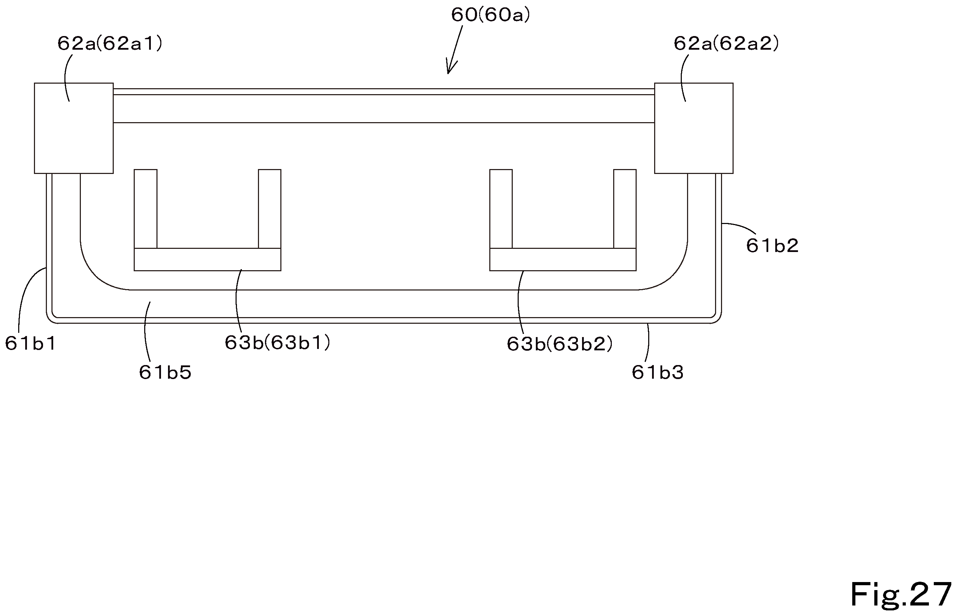

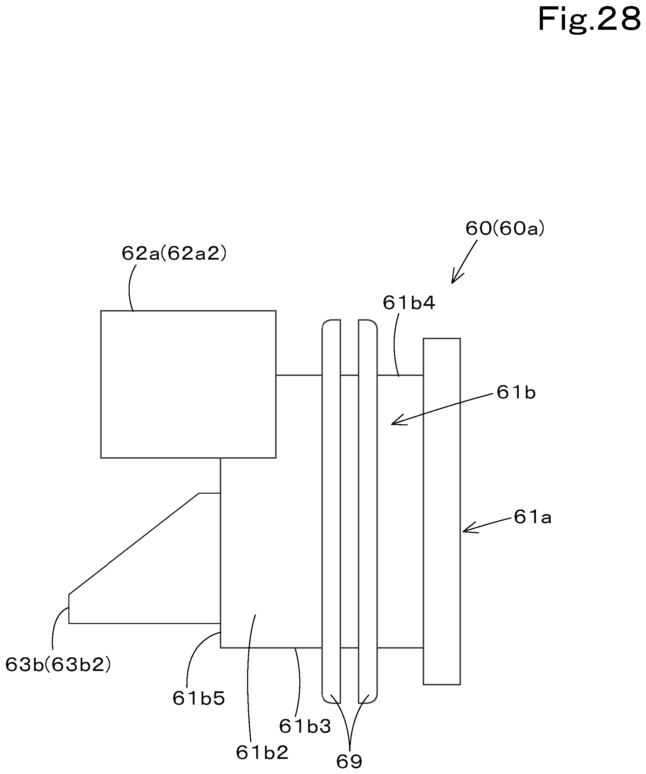

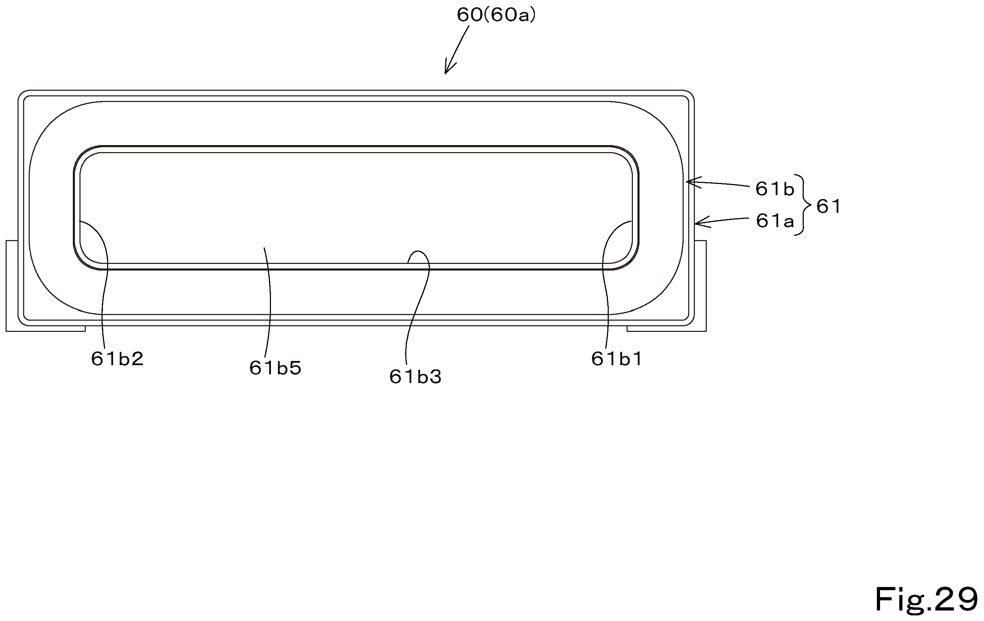

As shown in FIGS. 19 to 32, the cover 60 (60a, 60b) includes a main body 61 and an attachable portion 62. The main body 61 is a portion that is located at an unoccupied connector-receiving portion and that covers the unoccupied connector-receiving portion. The main body 61 includes an abutting portion 61a and a mount portion 61b. The abutting portion 61a and the mount portion 61b each include an elastic member such as rubber. The abutting portion 61a has an annular shape. The mount portion 61b is a rectangular parallelepiped which has an outer surface joined to the abutting portion 61a. The mount portion 61b includes a first section 61b1, a second section 61b2, a third section 61b3, a fourth section 61b4, and a fifth section 61b5.

The first section 61b1, the second section 61b2, the third section 61b3, the fourth section 61b4, and the fifth section 61b5 each have a sheet shape. The first section 61b1 and the second section 61b2 are separate from each other and opposed to (face) each other. The third section 61b3 and the fourth section 61b4 are separate from each other and opposed to (face) each other. The abutting portion 61a is joined to each of the first section 61b1, the second section 61b2, the third section 61b3, and the fourth section 61b4. The fifth section 61b5 joins the first section 61b1, the second section 61b2, the third section 61b3, and the fourth section 61b4 at the opposite side from the side where the abutting portion 61a is joined.

The mount portion 61b includes a receiving portion 63 to receive the connector seal portion 44 of the seal member 40. The receiving portion 63 includes a pair of projecting portions 69a and 69b projecting from the mount portion 61b. The pair of projecting portions 69a and 69b are provided at each of the first section 61b1, the second section 61b2, the third section 61b3 and the fourth section 61b4. The projection portions 69a and 69b are separate from each other and are configured to receive a protruding portion 48 of the connector seal portion 44 in a space therebetween.

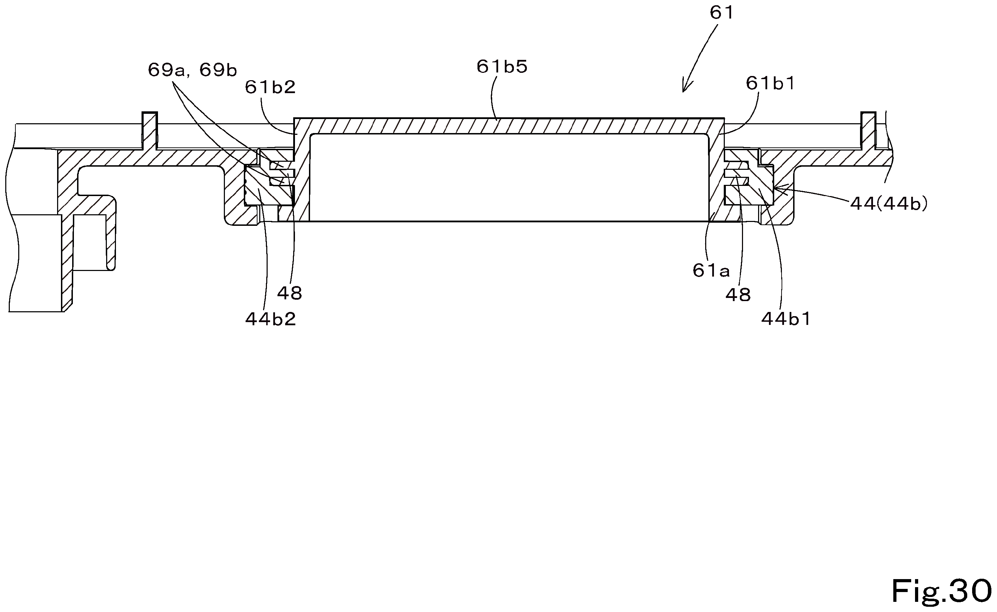

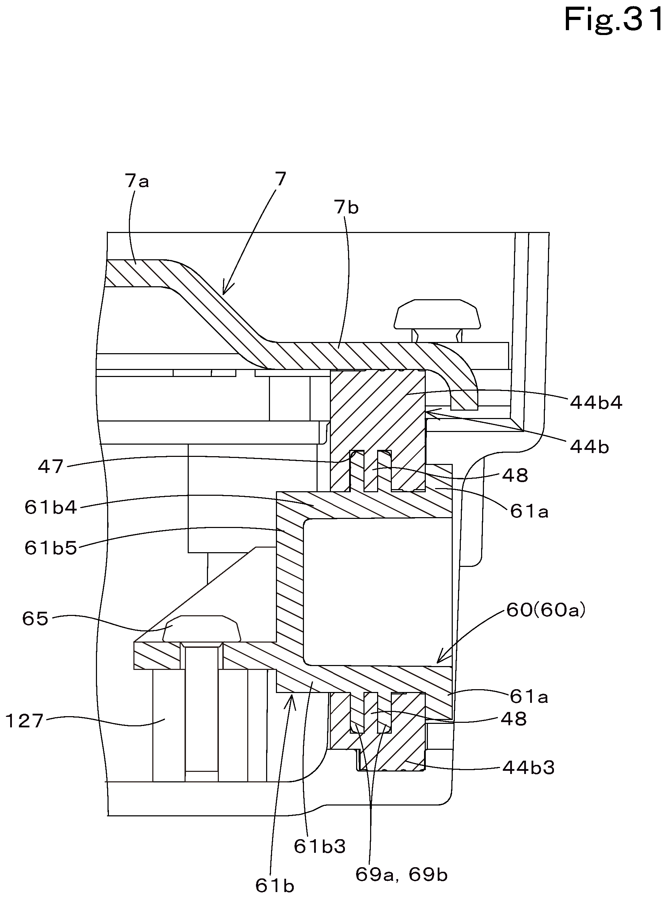

As shown in FIGS. 30 and 31, when the cover 60a is inserted in the insertion portion 46 of the connector seal portion 44a, a radially outer periphery of the first connector seal portion 44a contacts the abutting portion 61a. The portion (protruding portion 48) on each of the first opposing portion 44a1, the second opposing portion 44a2, the third opposing portion 44a3, and a fourth opposing portion 44a4 opposed to (facing) the third opposing portion 44a3 is configured to be fitted between the pair of projecting portions 69a and 69b provided at a corresponding one of the first section 61b1, the second section 61b2, the third section 61b3 and the fourth section 61b4.

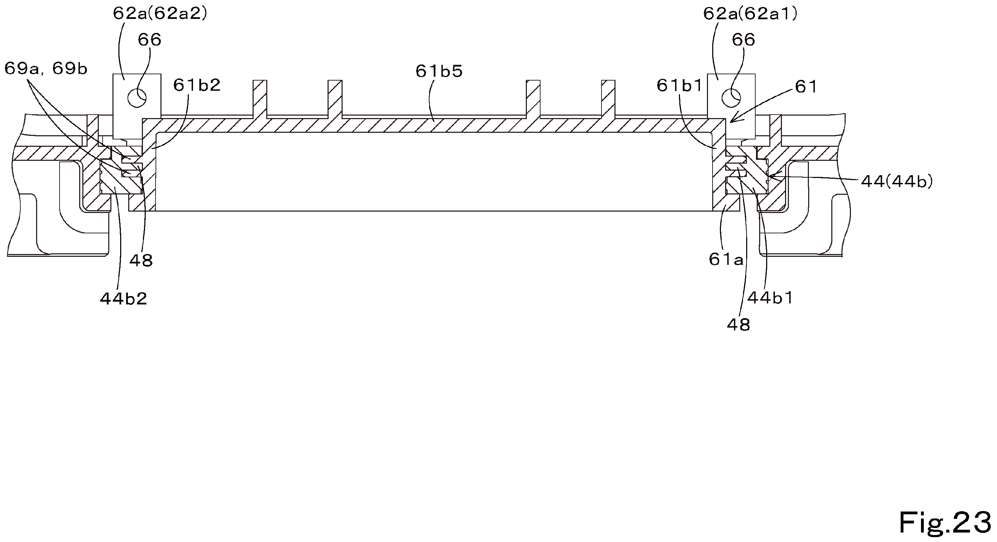

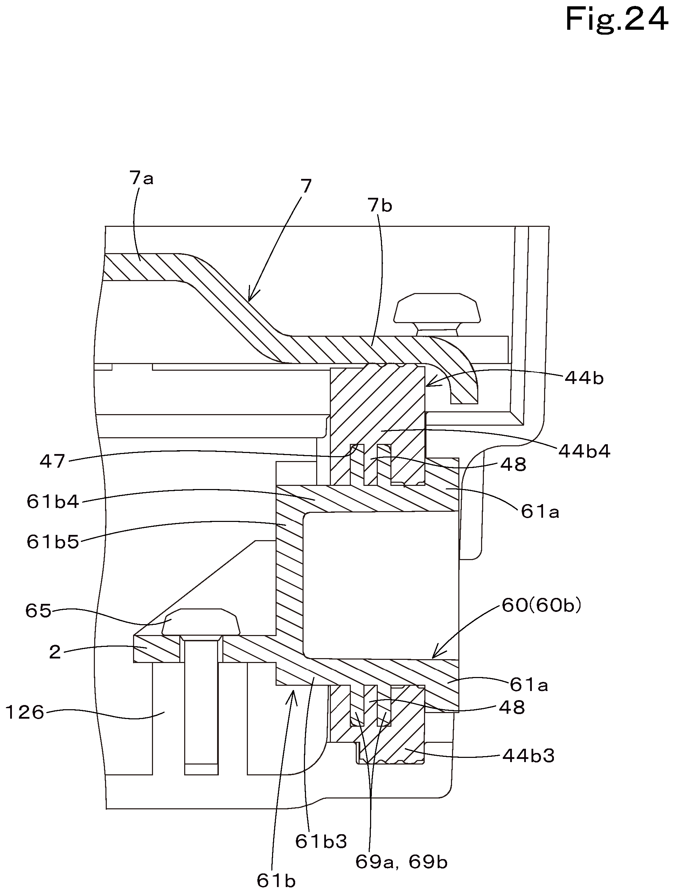

As shown in FIGS. 23 and 24, when the cover 60b is inserted in the insertion portion 47 of the second connector seal portion 44b, a radially outer periphery of the second connector seal portion 44b contacts the abutting portion 61a. The portion (protruding portion 48) on each of the first opposing portion 44b1, the second opposing portion 44b2, the third opposing portion 44b3 and a fourth opposing portion 44b4 opposed to (facing) the third opposing portion 44b3 is configured to be fitted between the pair of projecting portions 69a and 69b provided at a corresponding one of the first section 61b1, the second section 61b2, the third section 61b3 and the fourth section 61b4.

The attachable portion 62 is a portion joined to the main body 61 and attachable to the electronic substrate 2. The attachable portion 62 includes substrate attachable portion(s) 62a to be attached to the electronic substrate 2 and housing attachable portion(s) 63b to be attached to the housing 3. The substrate attachable portions 62a and the housing attachable portions 63b are attached to an inner one of the opposite sides of the main body 61 in the case-inward direction.

Specifically, at least two substrate attachable portions 62a are provided on the horizontal wall 10-side portion of the mount portion 61b. One of the substrate attachable portions (one substrate attachable portion 62a1) and another of the substrate attachable portions (the other substrate attachable portion 62a2) are separate from each other. The one substrate attachable portion 62a1 is attached to the first section 61b1, the third section 61b3 and the fifth section 61b5. The other substrate attachable portion 62a2 is attached to the second section 61b2, the third section 61b3 and the fifth section 61b5. The substrate attachable portions 62a (62a1, 62a2) each have a hole 66 for insertion of a fastener 65 such as a bolt.

At least two housing attachable portions 63b are provided on the horizontal wall 10-side portion of the mount portion 61b. One of the housing attachable portions (housing attachable portion 63b1) and another (housing attachable portion 63b2) are separate from each other. The housing attachable portions 63b1 and 63b2 are attached to the first section 61b1, the fourth section 61b4 and the fifth section 61b5. The other housing attachable portion 63b2 is attached to the second section 61b2, the fourth section 61b4 and the fifth section 61b5. The housing attachable portions 63b (63a1, 63a2) each have a hole 67 for insertion of a fastener 65 such as a bolt.

As shown in FIG. 25, in the case where a connector-receiving portion 18c is an unoccupied connector-receiving portion, when the cover 60b is attached to the unoccupied connector-receiving portion, the cover 60b is attached to the electronic substrate 2 by passing the fasteners 65 through holes 125 in the electronic substrate 2 and fastening the fasteners 65 to the holes 66 of the substrate attachable portions 62a (62a1, 62a2). Next, the electronic substrate 2 with the cover 60b attached thereto is fitted in the case body 6 and the cover 60b is fitted in the connector-receiving portion 18c. Furthermore, the cover 60b is attached to the housing 3 by passing the fasteners 65 through the housing attachable portions 63b (63a1, 63a2) of the cover 60b and fastening the fasteners 65 to fastening portions 126 provided on an inner surface of the case body 6. Note that the electronic substrate 2 includes a through portion 120 to allow the fasteners 65 to be inserted from the lid body 7 side when the cover 60b is attached to the housing 3. The through portion 120 is a cutout in the electronic substrate 2 provided such that the housing attachable portions 63b (63a1, 63a2).

As shown in FIG. 32, in a case where a connector-receiving portion 18a1 is an unoccupied connector-receiving portion, when the cover 60a is to be attached to the unoccupied connector-receiving portion, the cover 60a is attached to the unoccupied connector-receiving portion by passing the fasteners 65 through the holes 125 in the electronic substrate 2 and fastening the fasteners 65 to the holes 66 of the substrate attachable portions 62a (62a1, 62a2). Next, the electronic substrate 2 with the cover 60a attached thereto is fitted in the case body 6 and the cover 60a is fitted in the connector-receiving portion 18a1. Furthermore, the cover 60a is attached to the housing 3 by passing the fasteners 65 through the housing attachable portions 63b (63a1, 63a2) of the cover 60b and fastening the fasteners 65 to fastening portions 127 provided on the inner surface of the case body 6. Also when the cover 60a is attached to the housing 3, a through portion 120 allows the fasteners 65 to pass therethrough.

FIGS. 34 to 38 illustrate manners in which a plurality of connectors 5 attachable to the housing 3 are arranged. In FIGS. 34 to 38, different electronic substrates 2 corresponding to respective pluralities of connectors 5 are illustrated. That is, it is possible to provide various electronic devices by changing the electronic substrate 2 housed in the housing 3. Note that the same housing 3 can be used even when the electronic substrate 2 is changed.

The plurality of connectors 5 include first-type connector(s) and second-type connector(s) different from the first-type connector(s). The first-type connector is a connector having a boot shape. The connector having a boot shape includes a plug-in portion 50 that has a rectangular shape in plan view, and an extension portion 51 extending in a direction different from a plug-in direction B1 in which the connector is plugged in. The second-type connector includes a plug-in portion 52 that has a rectangular shape in plan view. Note that cap(s) 54 is/are provided at unoccupied connector-receiving portion(s) with no connectors 5 attached thereto and no covers 60 attached thereto.

As shown in FIG. 34, when the housing 3 is seen in plan view, a corner portion 101 is defined by the first vertical wall 20a of the peripheral wall 11 and the third vertical wall 20c of the peripheral wall 11. Assume here that the first vertical wall 20a is a first side and the third vertical wall 20c is a second side. A connector 5c that is a first-type connector and a connector 5a that is a second-type connector are attached to the housing 3 at the first side (first vertical wall 20a). A connector 5b that is a second-type connector is attached to the housing 3 at the second side (third vertical wall 20c).

A first harness 111 is connected to the first-type connector (connector 5c) connected to the first side (first vertical wall 20a), and a second harness 112 is connected to the second-type connector (connector 5b) connected to the second side (third vertical wall 20c). The second harness 112 passes through an area outward of the corner portion 101 and is guided in a direction C1 in which the first harness 111 extends. Another harness 115 different from the first harness 111 is connected to the second-type connector (connector 5a) connected to the first side (first vertical wall 20a). The first harness 111 and the other harness 115 are bundled together and guided in the direction C1.

That is, in the electronic device 1, the first-type connector 5c is attached to the first side (first vertical wall 20a) of the housing 3, and the second-type connector 5b is attached to the second side (third vertical wall 20c) of the housing 3, and the first side and the second side are different sides defining the corner portion 101 of the housing 3. The electronic device 1 includes the first harness 111 connected to the first-type connector (connector 5c) attached to the first side (first vertical wall 20a), and the second harness 112 connected to the second-type connector (connector 5b) attached to the second side (third vertical wall 20c).

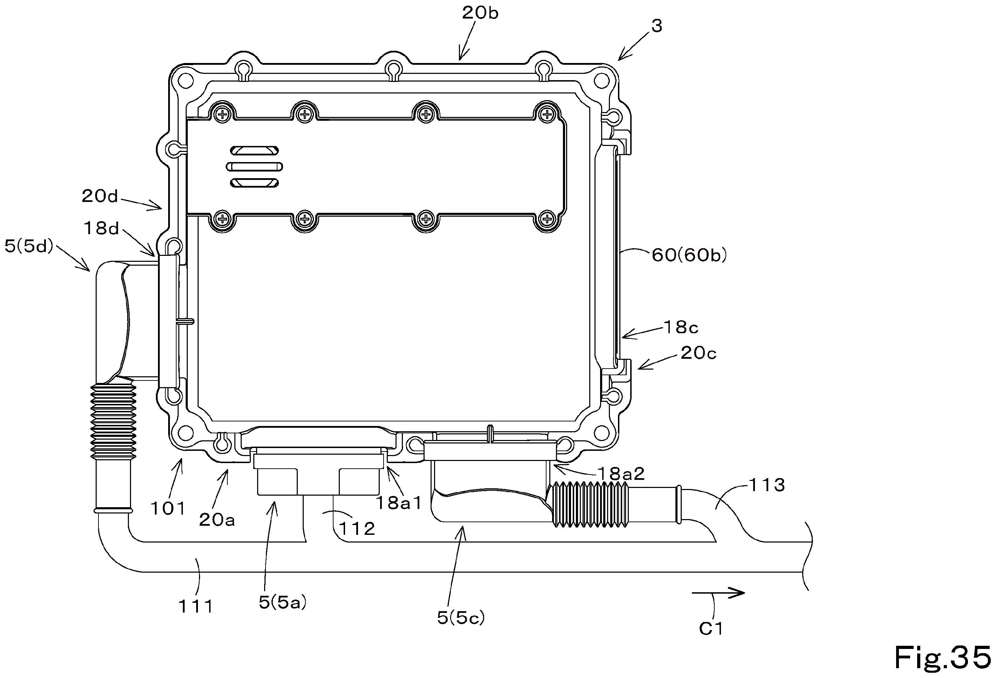

FIGS. 35 to 38 illustrate variations.

As shown in FIG. 35, assuming that the fourth vertical wall 20d is the first side and the first vertical wall 20a is the second side, a connector 5d that is a first-type connector is attached to the first side (fourth vertical wall 20d). A connector 5a that is a second-type connector and a connector 5c that is a first-type connector are attached to the second side (first vertical wall 20a).

A first harness 111 is connected to the first-type connector (connector 5d) attached to the first side (fourth vertical wall 20d), and a second harness 112 is connected to the second-type connector (connector 5a) attached to the second side (first vertical wall 20a). The second harness 112 is guided such that the second harness 112 extends in a direction away from the corner portion 101. A third harness 113 is connected to the first-type connector (connector 5c) attached to the second side (first vertical wall 20a). The third harness 113 is, similar to the second harness 112, guided such that the third harness 113 extends in a direction away from the corner portion 101.

The first harness 111 passes through an area outward of the corner portion 101, is bundled together with the second harness 112, and is guided in a direction C1 in which the second harness 112 extends. The first harness 111 and the second harness 112 are bundled together with the third harness 113 and guided in the direction C1 in which the third harness 113 extends.

In FIG. 35, the plurality of connectors include a plurality of first-type connectors 5d and 5c. The first-type connector 5d attached to the first side (fourth vertical wall 40a), and another one of the first-type connectors (first-type connector 5c) is attached to the second side (first vertical wall 20a). The electronic device 1 includes the first harness 111 connected to the first-type connector 5d attached to the first side (fourth vertical wall 40a), the second harness 112 connected to the second-type connector 5a attached to the second side (first vertical wall 20a), and the third harness 113 connected to the first-type connector 5c attached to the second side (first vertical wall 20a).

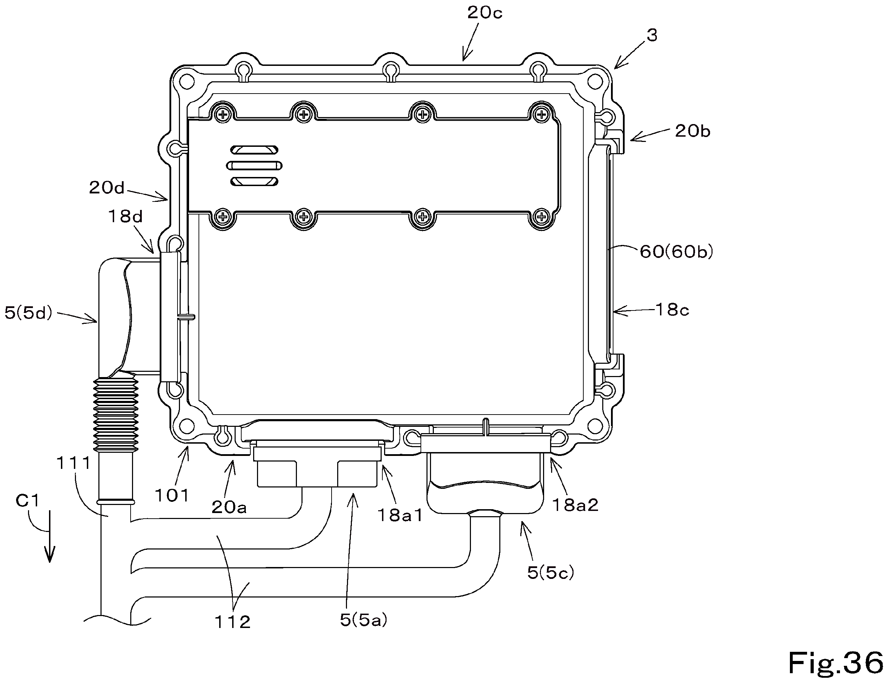

As shown in FIG. 36, a first-type connector 5d is attached to the first side (fourth vertical wall 20d), and second-type connectors 5a and 5b are attached to the second side (first vertical wall 20a). A first harness 111 connected to the connector 5d extends in the direction C1, a second harness 112 attached to the connectors 5a and 5b extends toward the corner portion 101 and is bundled together with the first harness 111 and extends in the direction C1.

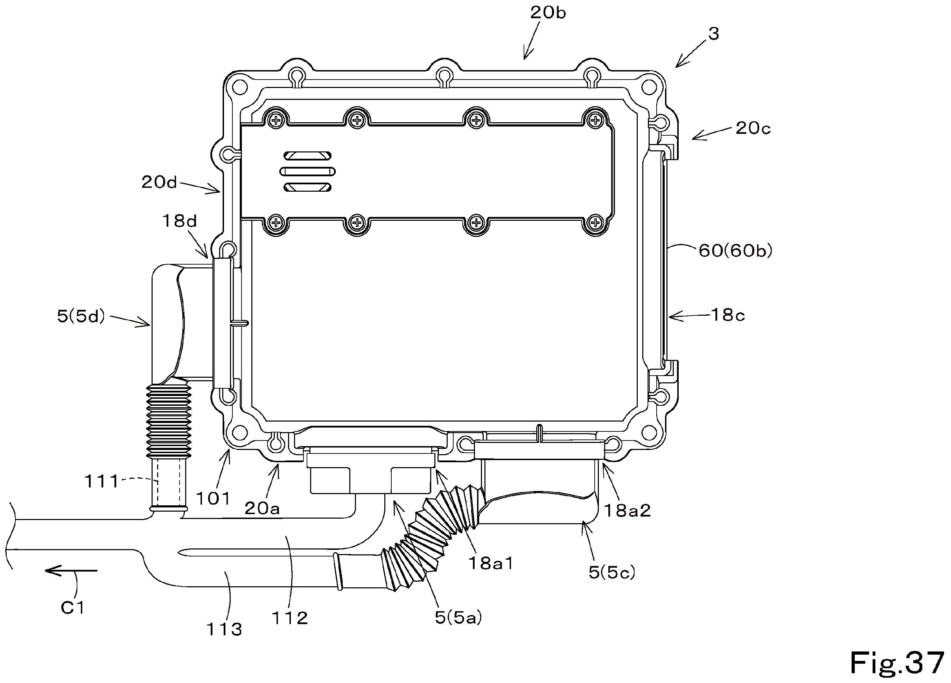

As shown in FIG. 37, a first-type connector 5d is attached to the first side (fourth vertical wall 20d), and a first-type connector 5c and a second-type connector 5a are attached to the second side (first vertical wall 20a). A first harness 111 connected to the connector 5 is guided in the direction C1 in which a second harness 112 attached to the connector 5a and a third harness 113 attached to the connector 5c extend.

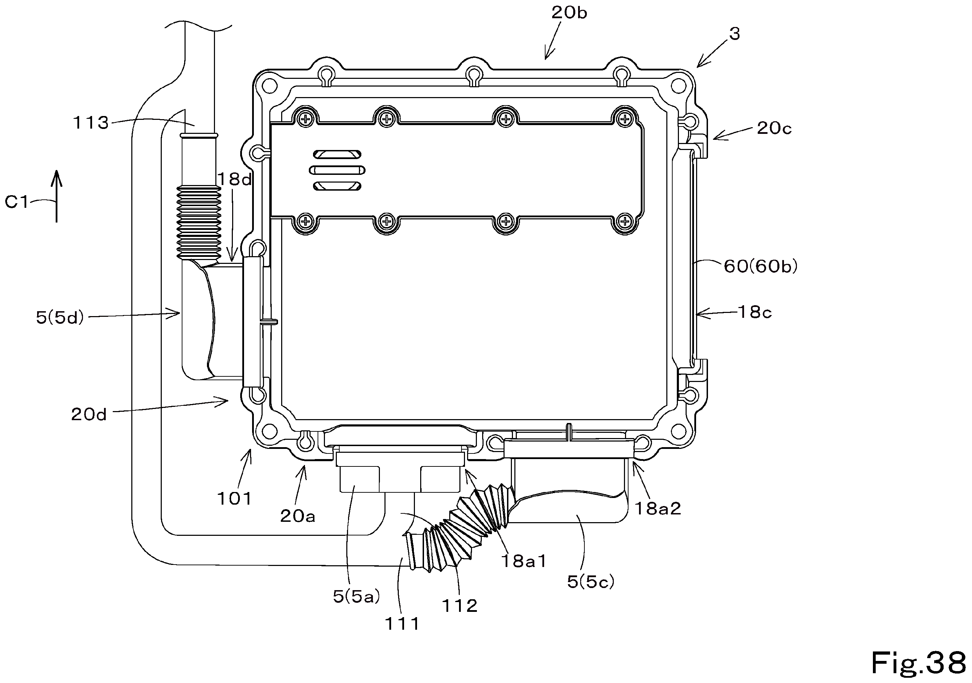

As shown in FIG. 38, a first-type connector 5c and a second-type connector 5a are attached to the first side (first vertical wall 20a). A first-type connector 5d is attached to the second side (fourth vertical wall 20d). A first harness 111 and a second harness 112 extend toward the corner portion 101 and are guided in the direction C1 in which a third harness 113 attached to the connector 5d extends.

Example embodiments of the present invention provide housings 3 and electronic devices 1 for industrial machines as described in the following items.

(Item A1) A housing 3 including a case body 6 to house an electronic substrate 2, a lid body 7 attachable to the case body 6, and a seal member 40 provided between the case body 6 and the lid body 7, wherein the seal member 40 includes a first seal portion 41 to contact the electronic substrate 2 and a second seal portion 42 located outward of the electronic substrate 2.

With the housing 3 according to item A1, since the first seal portion 41 contacts the electronic substrate 2, the first seal portion 41 improves the protection of the electronic substrate 2 against water, and also the second seal portion 42 improves the protection against water in the vicinity of the electronic substrate 2. That is, it is possible to achieve two-stage sealing with the first seal portion 41 and the second seal portion 42, and possible to achieve water resistance and airtightness. That is, the seal member 40 makes it possible to sufficiently eliminate or reduce the likelihood that foreign matter will reach the electronic substrate 2 (foreign matter will adhere to the electronic substrate 2).

(Item A2) The housing 3 according to item A1, wherein the second seal portion 42 includes an annular portion 43 located outward of the electronic substrate 2 and extending along an edge of the electronic substrate 2, and a connector seal portion 44 joined to the annular portion 43 and positioned at a connector-receiving portion 18 of the case body 6.

With the housing 3 according to item A2, it is possible to improve the sealability between the electronic substrate 2 and the connector 5 attached to the connector-receiving portion 18 when the electronic substrate 2 is sandwiched between the housing 3 and the lid body 7.

(Item A3) The housing 3 according to item A2, wherein the annular portion 43 and the connector seal portion 44 are integral with each other.

With the housing 3 according to item A3, it is possible to further improve the sealability between the electronic substrate 2 and the connector 5 attached to the connector-receiving portion 18.

(Item A4) The housing 3 according to any one of items A1 to A3, wherein the seal member 40 includes a joining portion 45 to join the first seal portion 41 and the second seal portion 42.

With the housing 3 according to item A4, the joining portion(s) 45 makes it possible to combine the first seal portion 41 with the second seal portion 42, making it easy to attach the seal member 40.

(Item A5) The housing 3 according to any one of items A1 to A4, wherein the case body 6 includes a seal groove 30 to receive the second seal portion 42.

With the housing 3 according to item A5, the seal groove 30 makes it easy to perform alignment of the second seal portion 42.

(Item A6) The housing 3 according to any one of items A1 to A5, wherein the first seal portion 41 extends in an annular manner along an edge of the electronic substrate 2 and is configured to contact the electronic substrate 2 when the lid body 7 is attached to the case body 6.

With the housing 3 according to item A6, it is possible to cause the edge of the electronic substrate 2 to more tightly fit against the case body 6 and the lid body 7.

(Item A7) The housing 3 according to any one of items A1 to A6, wherein the second seal portion 42 is located outward of the electronic substrate 2 and extends in an annular manner along the first seal portion 41, and is configured to contact the case body 6 and the lid body 7 when the lid body 7 is attached to the case body 6.

With the housing 3 according to item A7, it is possible to cause the second seal portion 42 to more tightly fit against the case body 6 and the lid body 7 at an area outward of the electronic substrate 2.

(Item A8) The housing 3 according to item A2 or any one of items A3 to A7 directly or indirectly depending from item A2, further including a guard portion 130 to guard the connector seal portion 44.

With the housing 3 according to item A8, since it is possible to guard the connector seal portion 44 with the guard portion 130, it is possible to eliminate or reduce the likelihood that, for example, water for car washing, etc., will reach the connector seal portion 44.

(Item A9) The housing 3 according to any one of items A1 to A8, wherein the case body 6 includes a rod body 55 extending from the case body 6 toward the lid body 7 to support the electronic substrate 2.

With the housing 3 according to item A9, when the electronic substrate 2 is supported by being sandwiched between the case body 6 and the lid body 7, the rod body 55 can support the electronic substrate 2.

(Item A10) The housing 3 according to item A9, wherein the case body 6 includes a horizontal wall 10 and a peripheral wall 11 joined to the horizontal wall 10, and the peripheral wall 11 includes a seal groove 30 to receive the second seal portion 42 in an inside thereof.

With the housing according to item A10, it is possible to perform alignment of the second seal portion 42 with the seal groove 30 of the peripheral wall 11, and possible to improve the airtightness (sealing performance) of the case body 6.

(Item B1) An electronic device 1 including a housing 3 to house an electronic substrate 2, the housing 3 including a plurality of connector-receiving portions 18 in a peripheral wall 11, at least one connector 5 located at at least one of the plurality of connector-receiving portions 18, and at least one cover 60 (60a, 60b) located at at least one unoccupied connector-receiving portion, which is at least one of the plurality of connector-receiving portions 18 at which no connectors 5 are located, wherein the at least one cover 60 (60a, 60b) includes a main body 61 which is located at the at least one unoccupied connector-receiving portion to cover the at least one unoccupied connector-receiving portion, and an attachable portion 62 joined to the main body 61 and attachable to the electronic substrate 2.

With the electronic device 1 according to item B1, when no connectors 5 are attached to the electronic device 1 to which a plurality of connectors 5 are attachable, the connector-receiving portion(s) 18 having no connectors 5 attached thereto can be easily closed with the cover(s) 60 (60a, 60b).

(Item B2) The electronic device 1 according to item B1, wherein the attachable portion 62 includes a substrate attachable portion 62a (62a1, 62a2) to be attached to the electronic substrate 2 and a housing attachable portion 63b (63a1, 63a2) to be attached to the housing 3.

With the electronic device 1 according to item B2, the cover 60 (60a, 60b) can be firmly secured by the substrate attachable portion(s) 62a (62a1, 62a2) and the housing attachable portion(s) 63b (63a1, 63a2), making it possible to improve the sealing properties provided by the cover 60 (60a, 60b).

(Item B3) The electronic device 1 according to item B2, wherein the housing attachable portion 63b (63a1, 63a2) is attached to the housing 3 by at least one fastener 65, and the electronic substrate 2 includes a through portion 120 to allow the at least one fastener 65 to pass therethrough.

With the electronic device 1 according to item B3, it is possible to fasten the fastener(s) 65 to the housing 3 after passing the fastener(s) 65 through the through portion 120, and thus possible to improve work performance when the cover(s) 60 (60a, 60b) is attached to the housing 3.

(Item B4) The electronic device 1 according to any one of items B1 to B3, wherein the housing 3 includes a case body 6 including a horizontal wall 10 and the peripheral wall 11 joined to the horizontal wall 10, and a lid body 7 attachable to the case body 6, and the peripheral wall 11 includes a seal groove 30 to receive a seal member 40 in an inside thereof.

With the electronic device 1 according to item B4, it is possible to easily perform alignment of the seal member 40 using the seal groove 30, and thus possible to improve the airtightness of the housing 3 with the seal member 40.

(Item C1) An electronic device 1 for an industrial machine, including a housing 3 having a box shape to house an electronic substrate 2, and a plurality of connectors 5 attachable to the housing 3, wherein the plurality of connectors 5 include a first-type connector and a second-type connector different from the first-type connector, and the first-type connector is attached to a first side of the housing 3 and the second-type connector is attached to a second side of the housing 3, the first side and the second side being different sides defining a corner portion 101 of the housing 3.

With the electronic device 1 for an industrial machine according to item C1, it is not only possible to easily attach the connectors 5 of different types (first-type connector, second-type connector) to the housing 3, but also to reduce the length of each side of the housing 3 as much as possible compared to cases where connectors of different types are attached to one side of the housing 3. That is, it is possible to make the electronic device 1 compact while improving the functionality of the electronic device 1.

(Item C2) The electronic device 1 according to item C1, further including a first harness 111 connected to the first-type connector attached to the first side, and a second harness 112 connected to the second-type connector attached to the second side, wherein the second harness 112 passes through an area outward of the corner portion 101 and is guided in a direction in which the first harness 111 extends.

With the electronic device 1 for an industrial machine according to item C2, it is possible to eliminate or reduce the likelihood that the harnesses (first harness 111, second harness 112) will surround the housing 3.

(Item C3) The electronic device 1 according to item C1, wherein the plurality of connectors 5 include a plurality of the first-type connectors, and one of the plurality of first-type connectors is attached to the first side, and another of the plurality of first-type connectors is attached to the second side.

With the electronic device 1 for an industrial machine according to item C3, it is possible, in a structure in which at least two first-type connectors are attached to the housing 3, to eliminate or reduce the likelihood that the connectors 5 will be arranged along one side of the housing 3 and the length of the side of the housing 3 will increase.

(Item C4) The electronic device 1 according to item C1, further including a first harness 111 connected to one of a plurality of the first-type connectors that is attached to the first side, a second harness 112 connected to the second-type connector attached to the second side, and a third harness 113 connected to another of the plurality of first-type connectors that is attached to the second side, wherein the first harness 111 passes through an area outward of the corner portion 101 and is guided in a direction in which the second harness 112 and the third harness 113 extend.

With the electronic device 1 for an industrial machine according to item C4, it is possible to eliminate or reduce the likelihood that the harnesses (first harness 111, second harness 112, third harness 113) will surround the housing 3.

(Item C5) The electronic device 1 according to any one of items C1 to C4, wherein the first-type connector is a connector having a boot shape.

With the electronic device 1 for an industrial machine according to item C5, it is possible, when attaching connector(s) having a boot shape, to both make it easier to guide harness(s) and make the housing 3 compact.

(Item D1) An electronic device 1 including a peripheral wall 11, a first wall (horizontal wall 10) provided at one of opposite sides in a height direction of the peripheral wall 11, a second wall (lid body 7) provided at the other of the opposite sides in the height direction of the peripheral wall 11, an electronic substrate 2 housed in a space defined by the peripheral wall 11, the first wall (horizontal wall 10) and the second wall (lid body 7), a container portion 14 provided at at least one of the first wall (horizontal wall 10) or the second wall (lid body 7) to house a device 16 different from the electronic substrate 2, and a discharging structure 90 to allow foreign matter in the container portion 14 to escape from the container portion 14 to at least one of an area outside the first wall (horizontal wall 10) or an area outside the second wall (lid body 7) and from the container portion 14 to an area outside the peripheral wall 11.

With the electronic device 1 according to item D1, even when foreign matter is in the container portion 14, the discharging structure 90 allows the foreign matter to escape toward the area outside the horizontal wall 10 and/or the area outside the peripheral wall 11, making it possible to improve the ability to allow foreign matter to escape.

(Item D2) The electronic device 1 according to item D1, wherein the container portion 14 includes a lid portion 15 to cover a portion for the device 16 to be housed, and the discharging structure 90 includes a first through-hole 94 in the lid portion 15, the first through-hole 94 being a hole through which an inside of the container portion 14 is in communication with at least one of the area outside the first wall (horizontal wall 10) or the area outside the second wall (lid body 7) and through which the container portion 14 is in communication with the area outside the peripheral wall 11.

With the electronic device 1 according to item D2, by merely providing the first through-hole(s) 94 in the lid portion 15, it is possible to allow foreign matter to escape through the first through-hole(s) 94 toward the area outside the horizontal wall 10 and/or the area outside the peripheral wall 11.

(Item D3) The electronic device 1 according to item D1, wherein the container portion 14 includes a lid portion 15 to cover a portion for the device 16 to be housed, and the discharging structure 90 includes a second through-hole 95 through which an inside of the container portion 14 is in communication with at least one of the area outside the first wall (horizontal wall 10) or the area outside the second wall (lid body 7), and a communication path 98 through which the area outside the peripheral wall 11 and the container portion 14 are in communication with each other.

With the electronic device 1 according to item D3, it is possible to allow foreign matter in the container portion 14 to escape toward the area outside the horizontal wall 10 and/or the area outside the peripheral wall 11 through the second through-hole(s) 95 and the communication path 98.

(Item D4) The electronic device 1 according to item D2 or D3, wherein the container portion 14 includes a lid support portion 70 to support the lid portion 15, a side wall 79 (79a, 79b) extending from the lid support portion 70 in a direction away from the lid portion 15, and a placement wall 78 (78a, 78b) joined to the side wall 79 (79a, 79b) and configured to allow the device 16 to be placed thereon.

With the electronic device 1 according to item D4, it is possible to stably house the device 16 with the side wall(s) 79 (79a, 79b) and the placement wall(s) 78 (78a, 78b).

(Item D5) The electronic device 1 according to item D4, wherein the lid support portion 70 includes a first mounting wall 71 provided at at least one of the first wall (horizontal wall 10) or the second wall (lid body 7), a second mounting wall 72 provided at at least one of the first wall (horizontal wall 10) or the second wall (lid body 7) and opposed to the first mounting wall 71, and a third mounting wall 73 to join the first mounting wall 71 and the second mounting wall 72, and the lid portion 15 is fitted between the first mounting wall 71 and the second mounting wall 72 such that the lid portion 15 is separate from the third mounting wall 73.

With the electronic device 1 according to item D5, it is possible to fit the lid portion 15 in the lid support portion 70, i.e., in the space defined by the mounting wall 71, the second mounting wall 72 and the third mounting wall 73 such that the lid portion 15 is separate from the third mounting wall 73, and thus possible to allow foreign matter in the container portion 14 to easily escape through the space between the third mounting wall 73 and the lid portion 15 to the outside.

(Item D6) The electronic device 1 according to item D5 depending from item D4 depending from item D2, wherein the lid portion 15 includes a first plate portion 15a opposed to the third mounting wall 73 and a second plate portion 15b extending from the first plate portion 15a along the peripheral wall 11, and the first through-hole 94 is provided in the first plate portion 15a and the second plate portion 15b.

With the electronic device 1 according to item D6, it is possible to easily extend the first through-hole(s) 94 to the peripheral wall 11, and thus possible to improve the ease of allowing foreign matter to escape toward the area outside the peripheral wall 11.

(Item D7) The electronic device 1 according to item D5 depending from item D4 depending from item D3, wherein the communication path 98 includes a recessed portion 70 defined by the first mounting wall 71, the second mounting wall 72 and the third mounting wall 73 and extending to the peripheral wall 11.

With the electronic device 1 according to item D7, the communication path 98 to allow foreign matter to pass therethrough easily can be defined by the recessed portion 70.

(Item D8) The electronic device 1 according to any one of items D2 to D7, wherein the device 16 includes an electric storage device 16a and an electrical device 16b to be actuated by the electric storage device 16a, the container portion 14 includes a first container chamber 81 to house the electric storage device 16a and a second container chamber 82 to house the electrical device 16b, and the lid portion 15 includes a partitioning portion 15c to separate the first container chamber 81 and the second container chamber 82 from each other.

With the electronic device 1 according to item D8, while achieving a structure in which the electrical device 16b can be easily actuated by the electric storage device 16a, it is possible to easily separate the first container chamber 81 to house the electric storage device 16a and the second container chamber 82 to house the electrical device 16b by the lid portion 15.

(Item D9) The electronic device 1 according to item D8, wherein the partitioning portion 15c is further configured to support the electrical device 16b.

With the electronic device 1 according to item D9, it is possible not only to separate the first container chamber 81 and the second container chamber 82 from each other by the lid portion 15, but also to easily support the electrical device 16b in the second container chamber 82.

(Item D10) The electronic device 1 according to item D9, wherein a first waterproof member 88 is provided at the lid portion 15 such that the first waterproof member 88 is on the same side of the partitioning portion 15c as the first container chamber 81.

With the electronic device 1 according to item D10, it is possible to improve the protection of the first container chamber 81 against water.

(Item D11) The electronic device 1 according to item D10, wherein a second waterproof member 89 different from the first waterproof member 88 and configured to contact the electric storage device 16a is provided at the lid portion 15.

With the electronic device 1 according to item D11, it is possible to eliminate or reduce the likelihood that foreign matter having entered the first container chamber 81 will reach the electric storage device 16a.

While the present invention have been described above, it is to be understood that the embodiments disclosed herein are considered as examples in all aspects and are not considered as limitations. The scope of the present invention is to be determined not by the foregoing description but by the claims, and is intended to include all variations and modifications within the scope of the claims and their equivalents.

### Reference Signs List

- 1: electronic device
- 2: electronic substrate
- 3: housing
- 5: connector
- 6: case body
- 7: lid body
- 10: horizontal wall
- 11: peripheral wall
- 18: connector-receiving portion
- 30: seal groove
- 40: seal member
- 60: cover
- 61: main body
- 62: attachable portion
- 62a: substrate attachable portion
- 63b: housing attachable portion
- 65: fastener
- 120: through portion

## Claims

1. An electronic device comprising:
a housing to house an electronic substrate, the housing including a plurality of connector-receiving portions in a peripheral wall;
at least one connector located at at least one of the plurality of connector-receiving portions; and
at least one cover located at at least one unoccupied connector-receiving portion which is at least one of the plurality of connector-receiving portions at which no connectors are located; wherein
the at least one cover includes a main body which is located at the at least one unoccupied connector-receiving portion to cover the at least one unoccupied connector-receiving portion, and an attachable portion joined to the main body and attachable to the electronic substrate.

2. The electronic device according to claim 1, wherein
the attachable portion includes a substrate attachable portion to be attached to the electronic substrate and a housing attachable portion to be attached to the housing.

3. The electronic device according to claim 2, wherein
the housing attachable portion is attached to the housing by at least one fastener; and
the electronic substrate includes a through portion to allow the at least one fastener to pass therethrough.

4. The electronic device according to claim 3, wherein
the housing includes:
a case body including a horizontal wall and the peripheral wall joined to the horizontal wall; and
a lid body attachable to the case body; and
the peripheral wall includes a seal groove to receive a seal member in an inside thereof.
